# EUROPÄISCHE PATENTSCHRIFT

(11) **EP 1 709 699 B1**
(45) Veröffentlichungstag und Bekanntmachung des Hinweises auf die Patenterteilung: **01.07.2009**
(21) Anmeldenummer: 04819213.2
(22) Anmeldetag: 24.11.2004
(51) Int. Cl.: H01L 51/30, H05B 33/14, C09K 11/06

(54) **KONJUGIERTE POLYMERE, DEREN DARSTELLUNG UND VERWENDUNG**
CONJUGATED POLYMERS, REPRESENTATION THEREOF, AND USE OF THE SAME
POLYMERES CONJUGUES, LEUR REPRESENTATION ET LEUR UTILISATION

(30) Priorität: 26.11.2003 DE 10355786
(43) Veröffentlichungstag der Anmeldung: 11.10.2006
(73) Patentinhaber: Merck Patent GmbH, 64293 Darmstadt (DE)
(72) Erfinder: PARHAM, Amir, 65929 Frankfurt (DE); HEUN, Susanne, 65812 Bad Soden (DE); BECKER, Heinrich, 65719 Hofheim (DE)
(86) Internationale Anmeldenummer: PCT/EP2004/013313
(87) Internationale Veröffentlichungsnummer: WO 2005/053054

(56) Entgegenhaltungen:
- US-A- 5 212 269
- US-A- 5 286 803
- US-A1- 2003 164 499
- DATABASE CA [Online] CHEMICAL ABSTRACTS SERVICE, COLUMBUS, OHIO, US; KARASAWA, AKIO ET AL: "Preparation of (diphenylamino)coumarins as charge-transporting agents for photoconductors" XP002319397 gefunden im STN Database accession no. 118:29980 -& JP 04 225364 A (MITSUI TOATSU CHEMICALS, INC., JAPAN) 14. August 1992 (1992-08-14)
- CHEN C-T, CHIANG C-L, LIN Y-C, CHAN L-H, HUANG C-H, TSAI Z-W, CHEN C-T: "Ortho-substituent effect on fluorescence and electroluminescence of arylamino-substituted coumarin and stilbene" ORGANIC LETTERS, Bd. 5, Nr. 8, 27. März 2003 (2003-03-27), Seiten 1261-1264, XP002319395
- PALMANS A.R.A., SMITH P., WEDER C.: "Polarizing energy transfer in photoluminescent conjugated polymers with covalently attached sensitizers" MACROMOLECULES, Bd. 32, 1999, Seiten 4677-4685, XP002319396 in der Anmeldung erwähnt

## Beschreibung

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch Grundlagenentwicklungen, welche in WO 90/13148 offenbart sind. Seit kurzem ist auch ein erstes, wenn auch einfaches, Produkt (eine kleine Anzeige in einem Rasierapparat der Fa. PHILIPS N.V.) auf dem Markt erhältlich. Allerdings sind immer noch deutliche Verbesserungen der verwendeten Materialien nötig, um diese Displays zu einer echten Konkurrenz zu den derzeit marktbeherrschenden Flüssigkristallanzeigen (LCD) zu machen.

Dabei ist es für die Erzeugung aller drei Emissionsfarben nötig, bestimmte Comonomere in die entsprechenden Polymere einzupolymerisieren (vgl. z. B. WO 00/46321, WO 03/020790 und WO 02/077060). So ist dann in der Regel - ausgehend von einem blau emittierenden Grundpolymer ("backbone") - die Erzeugung der beiden anderen Primärfarben Rot und Grün möglich.

Die konjugierten Polymere gemäß dem Stand der Technik zeigen zum Teil schon gute Eigenschaften in der Anwendung in PLEDs. Trotz der in den letzten Jahren erzielten Fortschritte entsprechen diese allerdings noch nicht den Anforderungen, die an sie für hochwertige Anwendungen gestellt werden. So ist die Photostabilität der Polymere gemäß dem Stand der Technik noch keineswegs zufriedenstellend, d. h. die Polymere zersetzen sich teilweise unter dem Einfluss von Licht. Dies gilt insbesondere bei Bestrahlung mit blauem und UV-Licht. Als Folge verringert sich die Effizienz der Lichtemission der Polymere drastisch. Es wäre also wünschenswert, hier Polymere zur Verfügung zu haben, die diese Probleme nicht zeigen, deren weitere Eigenschaften im Device jedoch unverändert gut oder besser sind als die Device-Eigenschaften der Polymere gemäß Stand der Technik.

Es wurde nun überraschend gefunden, dass konjugierte Polymere, die Cumarineinheiten bzw. deren Schwefel- oder Selenhomologen oder Chinolinoneinheiten als blau bzw. grün emittierende Einheit enthalten, sehr gute und den Stand der Technik übertreffende Eigenschaften aufweisen. Dies bezieht sich vor allem auf die Photostabilität, aber auch auf die Effizienz der Polymere. Diese Polymere und deren Verwendung in PLEDs sind daher Gegenstand der vorliegenden Erfindung.

Die Verwendung von Cumarinen in Verbindung mit Polymeren in organischen lichtemittierenden Dioden ist in der Literatur bereits beschrieben. In den meisten Fällen wird dabei allerdings ein Cumarinderivat zu einem Polymer gemischt (z. B. S. A. Swanson et al., Chem. Mater. 2003, 15, 2305). Diese Blends haben allerdings entscheidende Nachteile: Die Komponenten in Blends sind generell nicht ideal miteinander mischbar und neigen dadurch zu deutlich schlechterer Filmbildung, Phasentrennung im Film und/oder Kristallisation der Cumarin-Einheiten. Die Bildung eines homogenen Films, wie er für die Verwendung in Leuchtdioden essenziell ist, ist häufig nicht möglich. Auch eine Phasentrennung in der Vorrichtung bei längerem Betrieb wird beobachtet und führt zur Verringerung der Lebensdauer und zu Farbinstabilitäten. In EP 0278754 werden Cumarin-Derivate beschrieben, die mit mindestens einer Hydroxygruppe substituiert sind, die zur Anknüpfung als Seitengruppe von Polymeren genutzt werden können. Diese Polymere können als lichtemittierende Schicht in organischen Leuchtdioden verwendet werden. Allerdings handelt es sich bei den beschriebenen Polymeren um nicht-konjugierte Polymere. Es werden keine Devicedaten bei der Verwendung dieser Polymere in PLEDs angegeben, so dass davon ausgegangen werden muss, dass die so erzielten Spannungen und Lebensdauern nicht zufriedenstellend sind. Es ist zu vermuten, dass insbesondere die Spannung zu hoch ist, da der Ladungstransport durch nicht-konjugierte Polymere im Allgemeinen deutlich reduziert ist. Dies gilt auch für weitere nicht-konjugierte Polymere, die Cumarineinheiten in der Seitenkette enthalten und in mehreren Patentanmeldungen und Publikationen beschrieben sind (z. B. JP 04359989; EP 0661366; Z. Y. Lu et al., Chin. Chem. Lett. 2002, 13, 674; M. A. Tlenopatchev et al., Polymer J. 1997, 29, 622), ebenso wie für nicht-konjugierte Dendrimere (z. B. A. W. Freeman et a/., J. Am. Chem. Soc. 2000, 122, 12385). Dort wird für ein Dendrimer, das Cumarin über eine Esterverknüpfung an das Zentrum des Dendrimers gebunden hat, bei Verwendung in einer organischen Leuchtdiode eine externe Quanteneffizienz von nur 0.012 % angegeben, was deutlich hinter dem damaligen Stand der Technik zurückliegt und für eine kommerzielle Anwendung unbrauchbar ist. Auch nicht-konjugierte Polymere, die Cumarin in der Hauptkette enthalten, zeigen in der Elektrolumineszenz keine zufriedenstellenden Eigenschaften. So beschreiben beispielsweise S. Fomine et al. (Macromol. Chem. Phys. 1997, 198, 3065) aromatische Polyester mit Cumarin-Einheiten in der Hauptkette, die bei Verwendung in PLEDs eine Einsatzspannung von 6 - 8 V zeigen, was für die technische Anwendung deutlich zu hoch ist. Dieselben Autoren beschreiben weiterhin ähnliche Cumarin-haltige Polyester (Macromol. Chem. Phys. 1997, 198, 1679), die eine verbesserte Einsatzspannung von 4 V zeigen. Dennoch ist auch diese Spannung noch zu hoch für die technische Anwendung. Zudem sind keine Angaben zu Effizienzen und Lebensdauern gemacht, was darauf hindeutet, dass diese nicht zufriedenstellend sind, und die Polymere sind aus gesundheitlich bedenklichen Lösemitteln (chlorierten Kohlenwasserstoffen) zu verarbeiten. Cumarin-Einheiten, die über flexible, nicht-konjugierte Gruppen an Poly(phenylenethinylen) gebunden sind, werden von A. R. A. Palmans et al. (Macromolecules 1999, 32, 4677) beschrieben. Hier werden die Cumarineinheiten als photochemische Sensibilisatoren verwendet, die nach Bestrahlung ihre Energie auf das Polymer übertragen. Die Fluoreszenz erfolgt dann aus dem Polymergrundgerüst. Die Verwendung dieser Polymere als Elektrolumineszenzmaterialien wird nicht vorgestellt. Es ist allerdings nicht davon auszugehen, dass sich Polymere dieser Art für die Erzeugung von Lumineszenz aus den Cumarin-Einheiten eignen, da die Energie des Polymers niedriger liegt als die des Cumarins, so dass keine Emission aus der Cumarineinheit erfolgen kann.

Gegenstand der Erfindung sind konjugierte Polymere und Dendrimere, enthaltend mindestens 1 mol%, bevorzugt mindestens 5 mol%, besonders bevorzugt mindestens 10 mol% Einheiten gemäß Formel (1), 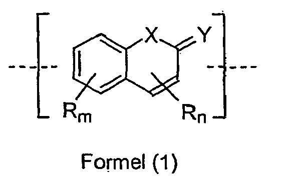 wobei die verwendeten Symbole und Indizes folgende Bedeutung besitzen:
- X: ist bei jedem Auftreten gleich oder verschieden Sauerstoff, Schwefel, Selen oder einer Gruppe N(R1);
- Y: ist bei jedem Auftreten gleich oder verschieden Sauerstoff, Schwefel oder Selen;
- R: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch -C(R1)=C(R1)-, -C≡C-, -N(R1)-, -O-, -S- , -CO-O- oder -O-CO-O- ersetzt sein können, wobei auch ein oder mehrere H- Atome durch Fluor ersetzt sein können, eine Aryl-, Heteroaryl- oder Aryloxygruppe mit 5 bis 40 C-Atomen, bei der auch ein oder mehrere C-Atome durch O, S oder N ersetzt sein können und welche auch durch ein oder mehrere nicht-aromatische Reste R substituiert sein kann, wobei auch zwei oder mehrere der Reste R miteinander ein aliphatisches oder aromatisches, mono- oder polycyclisches Ringsystem bilden können, oder Fluor, Chlor, Hydroxy, CN, N(R1)₂, Si(R1)₃ oder B(R1)₂;
- R1: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch -O-, -S-, -CO-O- oder -O-CO-O- ersetzt sein können, wobei auch ein oder mehrere H-Atome durch Fluor ersetzt sein können, eine Aryl- oder Heteroarylgruppe mit 5 bis 40 C-Atomen, bei der auch ein oder mehrere C- Atome durch O, S oder N ersetzt sein können und welche auch durch ein oder mehrere nicht-aromatische Reste R1 substituiert sein kann; dabei können auch mehrere Reste R1 bzw. R1 mit weiteren Resten R ein aromatisches oder aliphatisches, mono- oder polycyclisches Ringsystem bilden;
- m: ist bei jedem Auftreten gleich oder verschieden 0, 1, 2, 3 oder 4, mit der Maßgabe, dass m nicht 4 sein darf, wenn eine Verknüpfung zum Polymer direkt über den Carbocyclus verläuft, und mit der weiteren Maßgabe, dass m nicht 3 oder 4 sein darf, wenn beide Verknüpfungen zum Polymer direkt über den Carbocyclus verlaufen;
- n: ist bei jedem Auftreten gleich oder verschieden 0, 1 oder 2, mit der Maßgabe, dass n nicht 2 sein darf, wenn eine Verknüpfung zum Polymer direkt über den Heterocyclus verläuft, und mit der weiteren Maßgabe, dass n = 0 ist, wenn beide Verknüpfungen zum Polymer direkt über den Heterocyclus verlaufen;
ausgenommen konjugierte Poly(phenylenethinylene).

Die gestrichelte Bindung in Formel (1) ebenso wie in allen weiteren Formeln bedeutet die Verknüpfung im Polymer oder Dendrimer; sie soll hier keine Methylgruppe darstellen. Die Verknüpfung der Formel (1) kann entlang der Polymerhauptkette oder auch in der Polymerseitenkette erfolgen.

Konjugierte Polymere im Sinne dieser Erfindung sind Polymere, die in der Hauptkette hauptsächlich sp²-hybridisierte (bzw. gegebenenfalls auch sp-hybridisierte) Kohlenstoffatome, die auch durch entsprechende Heteroatome ersetzt sein können, enthalten. Dies bedeutet im einfachsten Fall abwechselndes Vorliegen von Doppel- und Einfachbindungen in der Hauptkette, aber auch Polymere mit Einheiten wie beispielsweise meta-verknüpftes Phenylen sollen im Sinne dieser Erfindung als konjugierte Polymere gelten. Hauptsächlich meint, dass natürlich (unwillkürlich) auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette beispielsweise Arylamineinheiten, Arylphosphineinheiten und/oder bestimmte Heterocyclen (d. h, Konjugation über N-, O-, P- oder S-Atome) und/oder metallorganische Komplexe (d. h. Konjugation über das Metallatom) befinden. Analoges gilt für konjugierte Dendrimere.

Unter dem Begriff Dendrimer soll hier eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum als auch die Monomere beliebige verzweigte Strukturen annehmen, die sowohl aus rein organischen Einheiten als auch Organometallverbindungen oder Koordinationsverbindungen bestehen. Dendrimer soll hier allgemein so verstanden werden, wie dies beispielsweise von M. Fischer und F. Vögtle (Angew. Chem., Int. Ed. 1999, 38, 885) beschrieben ist.

Die Einheiten gemäß Formel (1) können erfindungsgemäß in die Haupt- und/oder in die Seitenkette des Polymers eingebaut werden. Bei Einbau in die Seitenkette besteht die Möglichkeit, dass die Einheit gemäß Formel (1) in Konjugation mit der Polymerhauptkette steht oder dass sie nicht-konjugiert zur Polymerhauptkette ist.
In einer bevorzugten Ausführungsform der Erfindung steht die Einheit gemäß Formel (1) in Konjugation mit der Polymerhauptkette. Dies kann einerseits dadurch erreicht werden, dass diese Einheit in die Hauptkette des Polymers so eingebaut wird, dass dadurch die Konjugation des Polymers, wie oben beschrieben, erhalten bleibt. Andererseits kann diese Einheit auch in die Seitenkette des Polymers so verknüpft werden, dass eine Konjugation zur Hauptkette des Polymers besteht. Dies ist beispielsweise der Fall, wenn die Verknüpfung mit der Hauptkette nur über sp²-hybridisierte (bzw. gegebenenfalls auch über sp-hybridisierte) Kohlenstoffatome, die auch durch entsprechende Heteroatome ersetzt sein können, erfolgt. Erfolgt die Verknüpfung jedoch durch Einheiten, wie beispielsweise einfache (Thio)Etherbrücken, Ester, Amide oder Alkylenketten, so ist die Struktureinheit gemäß Formel (1) als nicht-konjugiert zur Hauptkette definiert.

Zum besseren Verständnis der folgenden Beschreibung wird hier die Nummerierung der Cumarineinheit (= 2H-Benzo-1-pyran-2-on) aufgezeigt; die Nummerierung der Schwefel-, Selen- und Stickstoffderivate erfolgt entsprechend:

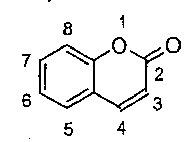

Der Einbau der Einheiten gemäß Formel (1) in die Hauptkette des konjugierten Polymers kann über zwei beliebige der Positionen 3, 4, 5, 6, 7 oder 8 erfolgen. Bevorzugt ist dabei, wenn die Verknüpfung so erfolgt, dass eine gerade Anzahl C-Atome zwischen den Verknüpfungspunkten liegt, also die Verknüpfung über die Positionen 3 und 4, 3 und 5, 3 und 7, 4 und 6, 4 und 8, 5 und 6, 5 und 8, 6 und 7 oder 7 und 8 erfolgt. Besonders bevorzugt ist es, wenn die Verknüpfung über die Benzo-Einheit erfolgt, insbesondere über die Positionen 5 und 8.

Die Verknüpfung der Einheiten gemäß Formel (1) in die Seitenkette des konjugierten Polymers kann über eine beliebige der Positionen 3, 4, 5, 6, 7 oder 8 erfolgen. Dabei ist es bevorzugt, wenn die Verknüpfung über die Benzo-Einheit erfolgt, also über die Position 5, 6, 7 öder 8. Besonders bevorzugt ist eine Verknüpfung über die Position 7. Dabei kann die Verknüpfung mit der Hauptkette über verschiedene Einheiten erfolgen. Bevorzugt ist eine Verknüpfung in Konjugation zur Hauptkette. Bevorzugte Einheiten zur Verknüpfung sind aromatische Einheiten, Di- und Triarylaminoeinheiten, Arylenvinylen- oder Arylenethinyleneinheiten.

Die erfindungsgemäßen Polymere enthalten bevorzugt neben Einheiten gemäß Formel (1) noch weitere Strukturelemente und sind somit als Copolymere zu bezeichnen. Hier sei vor allem auch auf die relativ umfangreichen Auflistungen in WO 02/077060, in der nicht offen gelegten Anmeldeschrift DE 10337346.2 und die darin aufgeführten Zitate verwiesen. Diese weiteren Struktureinheiten können beispielsweise aus den im Folgenden beschriebenen Klassen stammen:
Gruppe 1: Comonomere, welche das Polymer-Grundgerüst darstellen:
   Einheiten dieser Gruppe sind Einheiten, die aromatische, carbocyclische Strukturen mit 6 bis 40 C-Atomen beinhalten. Hier kommen Fluoren-Derivate (z. B. EP 0842208, WO 99/54385, WO 00/22027, WO 00/22026, WO 00/46321) in Betracht. Des Weiteren sind auch Spirobifluoren-Derivate (z. B. EP 0707020, EP 0894107, WO 03/020790) eine Möglichkeit. Auch Polymere, die eine Kombination der beiden erstgenannten Monomer-Einheiten enthalten, wie in WO 02/077060 offenbart, wurden bereits vorgeschlagen. In der nicht offen gelegten Anmeldung DE 10337346.2 sind Dihydrophenanthren-Derivate beschrieben. In WO 04/041901 und in EP 0301402.0 sind Indenofluoren-Derivate beschrieben. Es sind aber auch andere Strukturelemente möglich, die die Morphologie, aber auch die Emissionsfarbe der resultierenden Polymere beeinflussen können. Bevorzugt sind dabei substituierte oder unsubstituierte aromatische Strukturen, die 6 bis 40 C-Atome aufweisen oder auch Stilben-oder Bisstyrylarylenderivate, wie z. B. 1,4-Phenylen-, 1,4-Naphthylen-, 1,4- oder 9,10-Anthrylen-, 1,6- oder 2,7- oder 4,9-Pyrenylen-, Tetrahydropyrenylen-, 3,9- oder 3,10-Perylenylen-, 2,7- oder 3,6-Phenanthrenylen-, 4,4'-Biphenylylen-, 4,4"-Terphenylylen-, 4,4'-Bi-1,1'-naphthylylen-, 4,4'-Stilbenyl- oder 4,4"-Bisstyrylarylenderivaten. Bevorzugte Einheiten für das Polymergrundgerüst sind Spirobifluorene, Fluorene, Indenofluorene und Dihydrophenanthrene.
Gruppe 2: Comonomere, welche die Lochinjektions- und/oder -transporteigenschaften der Polymere erhöhen:
   Dies sind im Allgemeinen aromatische Amine oder elektronenreiche Heterocyclen, wie beispielsweise substituierte oder unsubstituierte Triarylamine, Benzidine, Tetraarylen-para-phenylendiamine, Phenothiazine, Phenoxazine, Dihydrophenazine, Thianthrene, Dibenzo-p-dioxine, Phenoxathiine, Carbazole, Azulene, Thiophene, Pyrrole, Furane und weitere O-, S-oder N-haltige Heterocyclen mit hoch liegendem HOMO (HOMO = höchst liegendes besetztes Molekülorbital). Es kommen hier aber auch Triarylphosphine in Frage, wie in der nicht offen gelegten Anmeldung EP 03018832.0 beschrieben.
Gruppe 3: Comonomere, welche die Elektroneninjektions- und/oder -transporteigenschaften der Polymere deutlich erhöhen:
   Dies sind im Allgemeinen elektronenarme Aromaten oder Heterocyclen, wie beispielsweise substituierte oder unsubstituierte Pyridine, Pyrimidine, Pyridazine, Pyrazine, Oxadiazole, Chinoline, Chinoxaline oder Phenazine, aber auch Verbindungen wie Triarylborane und weitere O-, S- oder N-haltige Heterocyclen mit niedrig liegendem LUMO (LUMO = niedrigstes unbesetztes Molekülorbital).

Dabei ist es auch zulässig, wenn gleichzeitig mehr als eine Struktureinheit aus einer der Gruppen 1-3 vorliegt.

Das Polymer kann weiterhin ebenfalls in die Haupt- oder Seitenkette gebundene Metallkomplexe enthalten, die im Allgemeinen aus einem oder mehreren Liganden und einem oder mehreren Metallzentren aufgebaut sind.

Bevorzugt sind erfindungsgemäße Polymere, die gleichzeitig neben Struktureinheiten gemäß Formel (1) zusätzlich noch ein oder mehrere Einheiten ausgewählt aus den Gruppen 1 bis 3 enthalten.
Bevorzugt sind dabei erfindungsgemäße Polymere, die neben Einheiten gemäß Formel (1) noch Einheiten aus der Gruppe 1 enthalten, besonders bevorzugt mindestens 50 mol% dieser Einheiten.
Ebenfalls bevorzugt ist es, wenn die erfindungsgemäßen Polymere Einheiten enthalten, die den Ladungstransport oder die Ladungsinjektion verbessern, also Einheiten aus Gruppe 2 und/oder 3; besonders bevorzugt ist ein Anteil von 2 - 30 mol% dieser Einheiten; ganz besonders bevorzugt ist ein Anteil von 10 - 20 mol% dieser Einheiten.
Besonders bevorzugt ist es weiterhin, wenn die erfindungsgemäßen Polymere Einheiten aus Gruppe 1 und Einheiten aus Gruppe 2 und/oder 3 enthalten, insbesondere mindestens 50 mol% Einheiten aus Gruppe 1 und 2 - 30 mol% Einheiten aus Gruppe 2 und/oder 3.

Weiterhin bevorzugt ist ein Anteil von 5 - 45 mol% Einheiten gemäß Formel (1). Besonders bevorzugt ist ein Anteil von 10 - 30 mol% Einheiten gemäß Formel (1).

Die erfindungsgemäßen Polymere weisen in der Regel 10 bis 10000, bevorzugt 20 bis 5000, besonders bevorzugt 50 bis 2000 Wiederholeinheiten auf. Entsprechende Dendrimere können auch weniger Wiederholeinheiten aufweisen.

Die nötige Löslichkeit der Polymere wird v. a. durch die Substituenten an den verschiedenen Wiederholeinheiten gewährleistet, sowohl den Substituenten R und R1 an Einheiten gemäß Formel (1), wie auch durch Substituenten an den anderen Wiederholeinheiten.

Bevorzugt sind weiterhin erfindungsgemäße Polymere, bei denen für Einheiten gemäß Formel (1) gilt:
- X: ist bei jedem Auftreten gleich oder verschieden Sauerstoff, Schwefel oder eine Gruppe N(R1);
- Y: ist bei jedem Auftreten gleich oder verschieden Sauerstoff oder Schwefel;
- m: ist bei jedem Auftreten gleich oder verschieden 0, 1, 2 oder 3, mit der Maßgabe, dass m nicht 3 sein darf, wenn beide Verknüpfungen zum Polymer direkt über den Carbocyclus verlaufen;
die weiteren Symbole und Indizes sind wie oben unter Formel (1) definiert.

Besonders bevorzugt sind weiterhin erfindungsgemäße Polymere, bei denen für Einheiten gemäß Formel (1) gilt:
- X: ist bei jedem Auftreten gleich oder verschieden Sauerstoff oder eine Gruppe N(R1);
- Y: ist bei jedem Auftreten Sauerstoff;
- m: ist bei jedem Auftreten gleich oder verschieden 0, 1 oder 2;
- n: ist bei jedem Auftreten gleich oder verschieden 0 oder 1;
die weiteren Symbole sind wie oben unter Formel (1) definiert.

Ganz besonders bevorzugt sind erfindungsgemäße Polymere, bei denen für Einheiten gemäß Formel (1) gilt:
- X: ist bei jedem Auftreten Sauerstoff;
- Y: ist bei jedem Auftreten Sauerstoff;
- m: ist bei jedem Auftreten gleich oder verschieden 0 oder 1;
- n: ist bei jedem Auftreten gleich oder verschieden 0 oder 1;
die weiteren Symbole sind wie oben unter Formel (1) definiert.

Beispiele für bevorzugte Strukturen gemäß Formel (1) zum Einbau in die Polymerhauptkette sind Strukturen gemäß Formel (2) bis (16), solche zum Einbau in die Polymerseitenkette sind Strukturen gemäß Formel (17) bis (26), wobei die Verknüpfung im Polymer jeweils durch die gestrichelten Bindungen angedeutet wird, und die Strukturen jeweils mit R substituiert oder unsubstituiert sein können. Es ist auch möglich, dass die Strukturen gemäß Formel (1) dimere (oder auch oligomere) Strukturen sind, die also zwei oder mehr solcher Einheiten aneinander gebunden enthalten. Beispiele für solche Strukturen sind Strukturen gemäß Formel (27) bis (28). 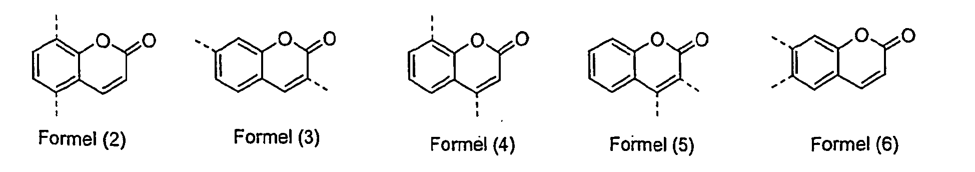 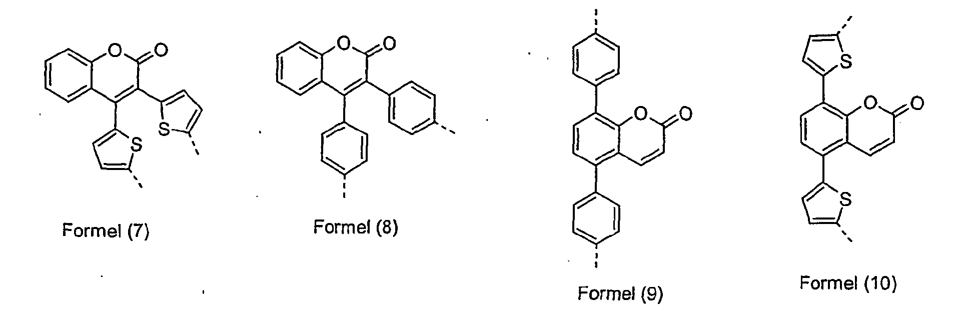 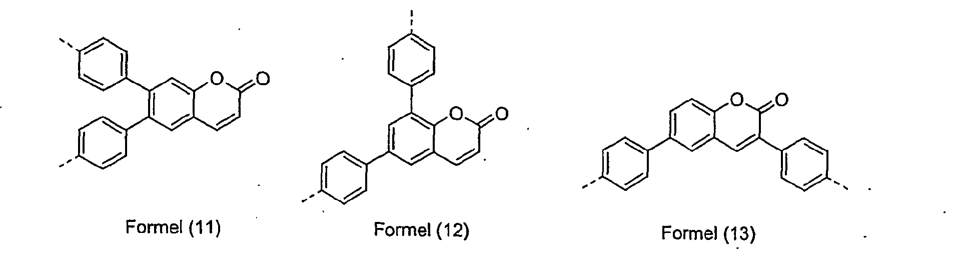 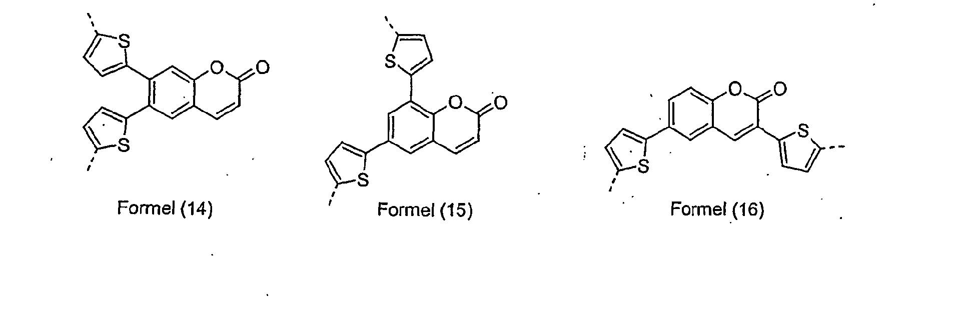 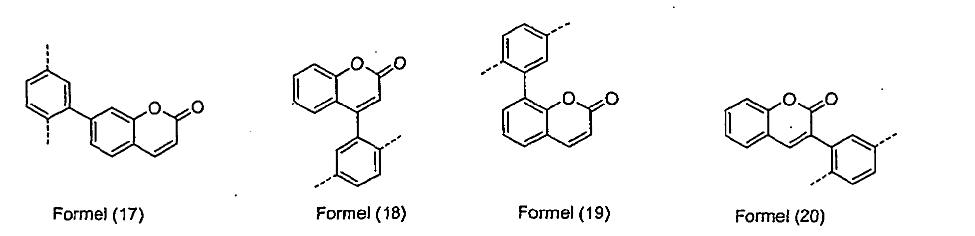 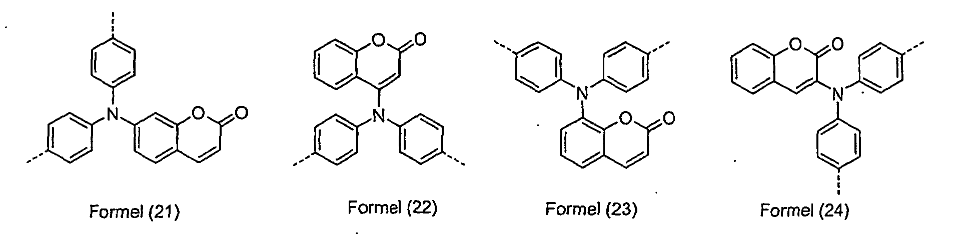 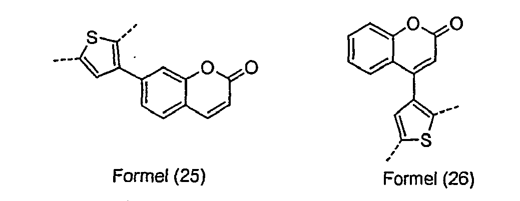 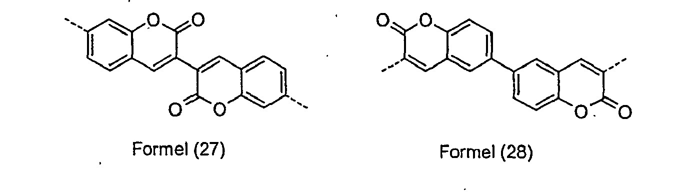 Die erfindungsgemäßen Polymere sind entweder Homopolymere aus Einheiten gemäß Formel (1) oder Copolymere. Erfindungsgemäße Copolymere können dabei neben einer oder mehreren Strukturen gemäß Formel (1), bzw. gemäß den Formeln (2) bis (28), potenziell eine oder mehrere weitere Strukturen aus den oben aufgeführten Gruppen 1 bis 3 besitzen.
Die erfindungsgemäßen Copolymere können statistische, alternierende oder blockartige Strukturen aufweisen oder auch mehrere dieser Strukturen abwechselnd besitzen. Wie Copolymere mit blockartigen Strukturen erhalten werden können und welche weiteren Strukturelemente dafür besonders geeignet sind, ist beispielsweise in der nicht offen gelegten Anmeldung DE 10337077.3 beschrieben. Ebenso sei an dieser Stelle nochmals hervorgehoben, dass das Polymer auch dendritische Strukturen haben kann.

Es kann auch bevorzugt sein, wenn ein deutlich geringerer Anteil als 1 mol% Struktureinheiten gemäß Formel (1) verwendet wird. So können 0.01 bis 1 mol% solcher Einheiten zum Beispiel als grün emittierende Einheiten für die Synthese weiß emittierender Copolymere verwendet werden. Hierfür wird im Allgemeinen ein sehr geringer Anteil grün emittierender Einheiten benötigt wird, wie in der nicht offen gelegten Anmeldung DE 10343606.5 beschrieben. Gegenstand der Erfindung ist also auch die Verwendung von Struktureinheiten gemäß Formel (1) für die Synthese weiß emittierender Copolymere. Ebenso können Struktureinheiten gemäß Formel (1) als grün (oder auch blau) emittierende Comonomere für die Synthese rot emittierender Polymere verwendet werden. Weiterer Gegenstand der Erfindung ist also die Verwendung von Struktureinheiten gemäß Formel (1) für die Synthese rot emittierender Polymere.

Die erfindungsgemäßen Polymere werden in der Regel durch Polymerisation von einer oder mehreren Monomersorten hergestellt, von denen mindestens ein Monomer durch die Formel (1) beschrieben ist. Entsprechende Polymerisationsreaktionen gibt es prinzipiell viele. Es haben sich hier jedoch einige Typen besonders bewährt, die alle zu C-C-Verknüpfungen führen:
(A) Polymerisation gemäß SUZUKI;
(B) Polymerisation gemäß YAMAMOTO;
(C) Polymerisation gemäß STILLE;
Wie die Polymerisation nach diesen Methoden durchgeführt werden kann und wie die Polymere dann vom Reaktionsmedium abgetrennt und aufgereinigt werden können, ist beispielsweise im Detail in WO 04/037887 beschrieben.

Zur Synthese der Polymere werden die entsprechenden Monomere benötigt.

Für die Synthese von Einheiten aus Gruppe 1 bis 3 sei an dieser Stelle nur auf DE 10337346.2 und die darin zitierte Literatur verwiesen.

Monomere, die in erfindungsgemäßen Polymeren zu Struktureinheiten gemäß Formel (1) führen, sind Cumarine und entsprechende Schwefel-, Selen- und Stickstoffderivate, die an geeigneten Positionen geeignet substituiert sind und geeignete Funktionalitäten aufweisen, die es erlauben, diese Monomereinheit in das Polymer einzubauen.

In der Literatur ist die Synthese verschiedener Mono- und Dibromcumarine und deren Derivate beschrieben, die direkt als Monomere für die Polymerisation eingesetzt bzw. durch Folgereaktionen weiter funktionalisiert werden können (z. B. Heterocycles 2003, 59, 217; Indian J. Chem., Sec. B 1999, 38B, 1242; Bioorganicheskaya Khimiya 1988, 14, 236; Ind. J. Chem., Sec. B 1982, 21B, 767; Chem. Phar. Bull. 1996, 44, 1986; Phosphorus, Sulfur and Silicon 2003, 178, 501; Ind. J. Chem., Sec. B 2000, 39B, 62; Can. J. Chem. 1982, 60, 1092; Chem. Phar. Bull. 1994, 42, 2170; Tetrahedron Lett. 2001, 42, 4849; Synlett 2002, 2059). Auch entsprechende Thio- und Selenocumarine (z. B. A. Ruwet, M. Renson, Bull. Soc. Chim. Be/g. 1968, 77, 465) sind bekannt, die ebenso funktionalisiert werden können. Entsprechend können die Stickstoffderivate synthetisiert werden.
Der Aufbau des Cumarin-Grundgerüstes kann durch die Perkin-Reaktion (W. H. Perkin, Liebigs Ann. Chem. 1868, 147, 229; J. Chem. Soc. 1868, 21, 53) oder Abwandlungen dieser Synthese im weitesten Sinne erfolgen. Dafür wird ein (gegebenfalls substituierter) Salicylaldehyd umgesetzt mit Acetanhydrid in Gegenwart von Natriumacetat (z. B. gemäß J. Kumanotani et al., J. Soc. Org. Synthet. Chem. 1953, 11, 388). In Variationen wird beispielsweise Salicylaldehyd unter sauren Bedingungen umgesetzt mit Verbindungen mit aktivierter Methylengruppe, z. B. Nitrilen (z. B. gemäß WO 03/050106). Eine weitere Möglichkeit ist die Reaktion von Phenolen mit β-Ketoestern unter sauren Bedingungen (z. B. gemäß HU 46315). Eine vollständige Auflistung aller Synthesemöglichkeiten würde den Umfang dieser Anmeldung sprengen. Der Fachmann der organischen Synthese kann aus den aufgelisteten Synthesewegen durch leichte Variationen eine Vielfalt nicht-halogenierter, monohalogenierter, dihalogenierter und oligohalogenierter Cumarine aufbauen.
Es werden generell zwei Synthesestrategien unterschieden: Bei der einen wird das vollständig aufgebaute Cumarin-Grundgerüst bromiert. Bei der anderen enthalten bereits die Edukte die Bromfunktionalität während des Aufbaus des Cumarin-Grundgerüsts. Je nach Zielverbindung kann die eine oder andere Syntheseroute bevorzugt sein.
Geeignete Bromierungsagenzien zur Synthese bromierter Cumarinderivate gibt es prinzipiell viele. So kommen beispielsweise Bromierungsagenzien in Frage, wie sie in WO 02/068435 aufgeführt sind. So kann beispielsweise durch Bromierung geeignet substituierter Cumarine ein Bromderivat erzeugt werden, das entweder direkt als Monomer in der Polymerisation eingesetzt werden kann oder durch Methoden, die dem Fachmann geläufig sind, beispielsweise in Boronsäurederivate oder Stannane umgesetzt werden kann, die dann ebenfalls in der Polymerisation eingesetzt werden können.
Bei der Bromierung zeigen sich allerdings Schwierigkeiten dadurch, dass das Proton in α-Stellung der ungesättigten Carbonylverbindung (Position 3 des Cumarins) ebenfalls durch Brom substituiert werden kann, insbesondere, wenn in Position 7 des Cumarins ein elektronenschiebender Substituent, wie beispielsweise eine Hydroxy-, Alkoxy- oder Aminogruppe, vorhanden sind. Dieser Bromsubstituent in Position 3 muss also nach der Bromierung wieder selektiv debromiert werden, beispielsweise durch Umsetzung mit einem Reduktionsmittel.

In der Literatur ist die Debromierung mit N,N-Dimethylanilin beschrieben (S. R. Ghantwal et al., Ind. J. Chem. 1999, 38B, 1242). Allgemein kommen hierfür Reduktionsmittel in Frage, deren Redoxpotential (gegen die Normalwasserstoffelektrode) in einem Bereich von -1.5 V bis 0.2 V liegt. Bevorzugt sind hierbei Metalle, deren Redoxpotential in diesem Bereich liegt, wie beispielsweise Eisen, Mangan, Nickel, Zink oder Zinn. Besonders bevorzugt ist Zink.

Monomere, die im Polymer zu Einheiten gemäß Formel (20) führen, sind neu und daher ebenfalls Gegenstand der vorliegenden Erfindung.

Weiterer Gegenstand der Erfindung sind bifunktionelle monomere Verbindungen gemäß Formel (29), 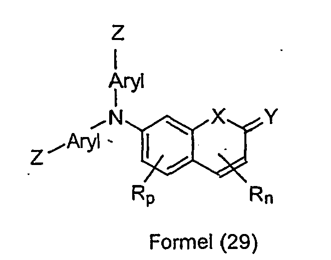 wobei Y, R, R1 und n dieselbe Bedeutung haben, wie unter Formel (1) beschrieben, und die anderen Symbole und Indizes folgende Bedeutung haben:
- X: ist bei jedem Auftreten gleich oder verschieden Sauerstoff, Schwefel oder Selen;
- Aryl: ist bei jedem Auftreten gleich oder verschieden ein aromatisches oder heteroaromatisches Ringsystem mit 2 bis 40 C-Atomen, welches durch R1 substituiert oder unsubstituiert sein kann, oder eine durch R1 substituierte oder unsubstituierte Stilbenyl-, Bisstilbenyl- oder Tolanyleinheit; die möglichen Substituenten R1 können dabei potenziell an jeder freien Position sitzen; dabei können mehrere Substituenten R1 miteinander oder mit weiteren Substituenten R ein aliphatisches oder aromatisches, mono- oder polycyclisches Ringsystem bilden;
- Z: ist bei jedem Auftreten gleich oder verschieden eine funktionelle Gruppe, die unter Bedingungen der C-C-Verknüpfungen copolymerisiert, bevorzugt Cl, Br, I, O- Tosylat, O-Triflat, O-SO₂R1, B(OR1)₂ oder Sn(R1)₃;
- p: ist bei jedem Auftreten gleich oder verschieden 0, 1, 2 oder 3, bevorzugt 0 oder 1, besonders bevorzugt 0.

Die C-C-Verknüpfungen sind dabei bevorzugt ausgewählt aus den Gruppen der SUZUKI-Kupplung, der YAMAMOTO-Kupplung und der STILLE-Kupplung.

Die erfindungsgemäßen Polymere weisen gegenüber den in WO 03/020790 beschriebenen Poly-Spirobifluorenen, den in WO 02/077060 beschriebenen Polyfluorenen und den in DE 10337346.2 beschriebenen Poly-Dihydrophenanthrenen, die keine Einheiten gemäß Formel (1) enthalten und die hier als nächstliegender Stand der Technik genannt werden, folgende Vorteile auf:
(1) Die erfindungsgemäßen Polymere zeigen eine höhere Photostabilität im Vergleich zu Polymeren gemäß dem Stand der Technik. Dies ist von entscheidender Bedeutung für die Anwendung dieser Polymere, da sie sich weder durch die durch Elektrolumineszenz freigesetzte Strahlung, noch durch von außen einfallende Strahlung zersetzen dürfen. Diese Eigenschaft ist bei Polymeren gemäß dem Stand der Technik noch mangelhaft.
(2) Die erfindungsgemäßen Polymere weisen (bei ansonsten gleicher oder ähnlicher Zusammensetzung) vergleichbare oder höhere Leuchteffizienzen in der Anwendung auf. Dies ist von enormer Bedeutung, da somit entweder gleiche Helligkeit bei geringerem Energieverbrauch erzielt werden kann, was vor allem bei mobilen Applikationen (Displays für Handys, Pager, PDA, etc.), die auf Batterien und Akkus angewiesen sind, sehr wichtig ist. Umgekehrt erhält man bei gleichem Energieverbrauch höhere Helligkeiten, was beispielsweise für Beleuchtungsanwendungen interessant sein kann.
(3) Des Weiteren hat sich überraschend gezeigt, dass wiederum im direkten Vergleich die erfindungsgemäßen Polymere vergleichbare oder höhere operative Lebensdauern aufweisen.

Es kann außerdem bevorzugt sein, das erfindungsgemäße Polymer nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern oder selber emittieren. Solche Blends sind daher auch Bestandteil der vorliegenden Erfindung.

Gegenstand der Erfindung sind weiterhin Lösungen und Formulierungen aus einem oder mehrere erfindungsgemäßen Polymeren oder Blends in einem oder mehreren Lösungsmitteln. Wie Polymerlösungen hergestellt werden können, ist beispielsweise beschrieben in WO 02/072714, WO 03/019694 und der darin zitierten Literatur.
Diese Lösungen können verwendet werden, um dünne Polymerschichten herzustellen, zum Beispiel durch Flächenbeschichtungsverfahren (z. B. Spin-coating) oder durch Druckverfahren (z. B. InkJet Printing).

Die erfindungsgemäßen Polymere können in PLEDs verwendet werden. Wie PLEDs hergestellt werden können, wird als allgemeines Verfahren ausführlich in WO 04/037887 beschrieben, das entsprechend für den Einzelfall anzupassen ist.
Wie oben beschrieben, eignen sich die erfindungsgemäßen Polymere ganz besonders als Elektrolumineszenzmaterialien in derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Polymers oder Blends in einer PLED, insbesondere als Elektrolumineszenzmaterial.

Gegenstand der Erfindung ist somit ebenfalls eine PLED mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht und/oder eine Transportschicht und/oder eine Ladungsinjektionsschicht sein.

Im vorliegenden Anmeldetext und auch in den im Weiteren folgenden Beispielen wird auf die Verwendung erfindungsgemäßer Polymere oder Blends in Bezug auf PLEDs und entsprechende Displays abgezielt. Trotz dieser Beschränkung der Beschreibung ist es für den Fachmann ohne weiteres erfinderisches Zutun möglich, die erfindungsgemäßen Polymere als Halbleiter auch für weitere Verwendungen in anderen elektronischen Devices (Vorrichtungen) zu benutzen, z. B. in organischen Feld-Effekt-Transistoren (O-FETs), in organischen integrierten Schaltungen (O-ICs), in organischen Dünnfilmtransistoren (O-TFTs), in organischen Solarzellen (O-SCs) oder auch in organischen Laserdioden (O-Laser), um nur einige Anwendungen zu nennen.
Die Verwendung der erfindungsgemäßen Polymere in den entsprechenden Vorrichtungen ist ebenfalls ein Gegenstand der vorliegenden Erfindung.

Ebenso ist es für den Fachmann ein Leichtes, die oben gemachten Beschreibungen für konjugierte Polymere ohne weiteres erfinderisches Zutun auf konjugierte Dendrimere zu übertragen. Solche konjugierten Dendrimere sind also auch Gegenstand der vorliegenden Erfindung.

### Beispiele:

### Beispiel 1: Synthese des erfindungsgemäßen Diarylamin-substituierten Cumarin-Monomers CUM1

### a) 2-(3-Bromphenoxy)tetrahydropyran

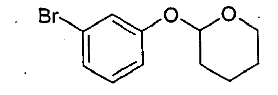

Zu 43.4 mL (474.8 mmol) 3,4-Dihydropyran und 15 Tropfen konzentrierter Salzsäure wurde eine Lösung aus 74.66 g (431.6 mmol) 3-Bromphenol in 1500 mL Dichlormethan unter schnellem Rühren getropft. Die Mischung wurde über Nacht bei Raumtemperatur gerührt und anschließend mit 300 mL 1 N NaOH versetzt. Die organische Phase wurde abgetrennt, über MgSO₄ getrocknet und das Lösungsmittel im Vakuum entfernt. Das reine Produkt erhielt man durch Umkristallisation aus Hexan. Die Ausbeute, bei einer Reinheit von 96 % nach HPLC, betrug 104 g (94 % d. Th.).
¹H-NMR (CDCl₃, 500 MHz): 1.52-2.15 (m, 6H), 3.56 (m, 1 H), 3.88 (m, 1H), 5.41 (t, J = 3.3 Hz, 1H), 6.98 (dd, ²J = 7.3 Hz, ³J = 1.6 Hz, 1H), 7.11 (d, J = 1.6 Hz, 1H), 7.13 (d, J = 7.3 Hz, 1H), 7.23 (d, J = 1.6 Hz, 1 H).

### b) N,N-Diphenyl-[N-3-(tetrahydropyran-2-yloxy)phenyl]amin

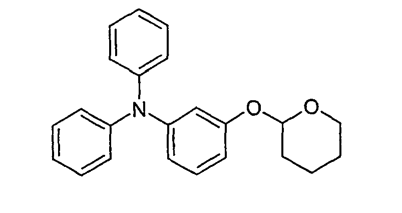

Eine entgaste Lösung von 56.2 g (332 mmol) Diphenylamin und 100 g (365 mmol) 2-(3-Bromphenoxy)tetrahydropyran in 1000 mL Toluol wurde 1 h mit N₂ gesättigt. Dann wurde die Lösung zuerst mit 1.35 g (6.67 mmol) P(tBu)₃, dann mit 0.748 g (3.3 mmol) Pd(OAc)₂ versetzt und anschließend 3.8 g (50.4 mmol) NaOtBu als Feststoff zugegeben. Die Reaktionsmischung wurde 5 h unter Rückfluss erhitzt. Nach Abkühlen auf Raumtemperatur wurden vorsichtig 5 g NaCN und 300 mL Wasser zugesetzt. Die organische Phase wurde mit 4 x 100 mL H₂O gewaschen, über MgSO₄ getrocknet und die Lösungsmittel in Vakuum entfernt. Das reine Produkt erhielt man durch Umkristallisation aus Hexan. Die Ausbeute, bei einer Reinheit von 91.3 % nach HPLC, betrug 100 g (80 % d. Th.).
¹H-NMR (CDCl₃, 500 MHz): 1.52-2.15 (m, 6H), 3.56 (m, 1H), 3.88 (m, 1H), 5.41 (t, J = 3.3 Hz, 1H), 6.68 (m, 1H), 6.71 (m, 1H), 6.76 (d, J = 2.3 Hz, 1H), 7.00 (t, J = 7.3 Hz, 2H), 7.09 (d, J = 8.3 Hz, 4H), 7.13 (t, J = 8.3 Hz, 1H), 7.23 (dd, ²J = 8.3 Hz, ³J = 7.3 Hz, 4H).

### c) 3-(N,N-Diphenylamino)phenol

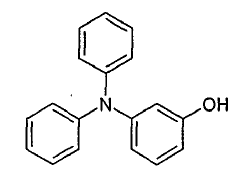

87 g (251 mmol) Diphenyl-[N-3-(tetrahydropyran-2-yloxy)phenyl]amin wurden in 500 mL MeOH vorgelegt und auf 50 °C erhitzt. Unter Rühren wurden 9.4 g (50 mmol) p-Toluolsulfonsäure zugegeben und über Nacht gerührt. Die Mischung wurde mit 100 mL Wasser versetzt, die organische Phase abgetrennt, über MgSO₄ getrocknet und die Lösungsmittel in Vakuum entfernt. Das reine Produkt erhielt man durch Umkristallisation aus Hexan/MeOH (3:1). Die Ausbeute, bei einer Reinheit von 95.4 % nach HPLC, betrug 59 g (90 % d. Th.).
¹H-NMR (CDCl₃, 500 MHz): 4.9 (s, 1H), 6.43 (m, 1H), 6.50 (t, J = 7.3 Hz, 1H), 6.61 (m, 1H), 7.00 (t, J = 7.3 Hz, 2H), 7.06 (t, J = 8.3 Hz, 1H), 7.34 (d, J = 8.3 Hz, 4H), 7.22 (dd, ²J = 8.3 Hz, ³J = 7.3 Hz, 4H).

### d) 7-(N,N-Diphenylamino)-4-methylcumarin

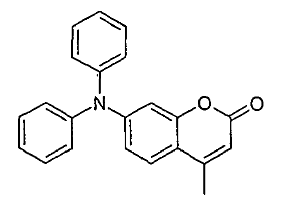

Eine Mischung aus 73 g (292 mmol) 3-(N,N-Diphenylamino)phenol, 38 g (292 mmol) Acetessigsäureethylester und 350 mL Nitrobenzol wurde auf 100 °C erhitzt. Dazu wurden 77.3 g (584 mmol) wasserfreies Aluminiumtrichlorid portionsweise zugegeben und 3 h auf 130 °C erhitzt. Die Reaktionsmischung wurde abgekühlt und bei Raumtemperatur mit 75 mL halbkonzentrierter Salzsäure versetzt. Das reine Produkt erhielt man durch Umkristallisation aus Ethylacetat. Die Ausbeute, bei einer Reinheit von 97 % nach HPLC, betrug 59 g (54 %). ¹H-NMR (CDCl₃, 500 MHz): 2.38 (s, 3H), 6.08 (s, 1H), 6.83 (d, J = 2.3 Hz 1H), 6.88 (dd, ²J = 8.7 Hz, ³J = 2.3 Hz, 1H), 7.15 (t, J = 7.3 Hz, 2H), 7.16 (d, J = 9.0 Hz, 4H), 7.35 (m, 5H).

### e) 7-[N,N-Bis(4-bromphenyl)amino]-3-brom-4-methylcumarin

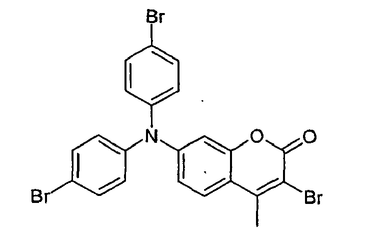

2.4 g (7.47 mmol) 7-(N,N-Diphenylamino)-4-methylcumarin in 35 mL CHCl₃ wurden auf 0 °C gekühlt, unter Lichtausschluss portionsweise mit 3.9 g (22.2 mmol) NBS versetzt und über Nacht bei Raumtemperatur gerührt. Anschließend wurde die Mischung mit 40 mL Na₂SO₃-Lösung versetzt. Die Phasen wurden getrennt, die organische Phase über MgSO₄ getrocknet und die Lösungsmittel in Vakuum entfernt. Der Rückstand wurde durch Umkristallisation aus Ethylacetat aufgereinigt. Die Ausbeute, bei einer Reinheit von 98 % nach HPLC, betrug 3 g (90 % d. Th.).
¹H-NMR (CDCl₃, 500 MHz): 2.58 (s, 3H), 6.84 (d, J = 2.3 Hz, 1H), 6.90 (dd, ²J = 9.0 Hz, ³J = 2.3 Hz, 1H), 7.01 (d, J = 9.0 Hz, 4H), 7.44 (d, J = 9.0 Hz, 1H), 7.46 (d, J = 9.0 Hz, 4H).

### f) 7-[N,N-Bis(4-bromphenyl)amino]-4-methylcumarin (Monomer CUM1)

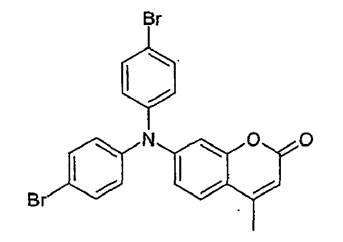

Eine Mischung aus 16 g (250 mmol) Zinkstaub und 100 mL Eisessig wurde mit 12 g (37.3 mmol) 7-[N,N-Bis(4-bromphenyl)amino]-3-brom-4-methylcumarin versetzt. Die Rektionsmischung wurde 3 Tage bei 80 °C gerührt. Anschließend wurde das Gemisch mit 250 mL Wasser gewaschen, der Rückstand abfiltriert und das Produkt aus Aceton/Hexan (1:2) umkristallisiert. Die Ausbeute, bei einer Reinheit von 99.8 % nach HPLC, betrug 4.6 g (80 % d. Th.).
¹H-NMR (CDCl₃, 500 MHz): 2.58 (s, 3H), 6.12 (s, 1H), 6.85 (d, J = 2.3 Hz, 1H), 6.88 (dd, ²J = 9.0 Hz, ³J = 2.3 Hz, 1H), 7.01 (d, J = 9.0 Hz, 4H), 7.40 (d, J = 9.0 Hz, 1H), 7.55 (d, J = 9.0 Hz, 4H).

### Beispiel 2: Synthese weiterer Comonomere

Die Strukturen der weiteren Monomere **(M)** für erfindungsgemäße Polymere und Vergleichspolymere sind im Folgenden abgebildet. Die Synthese der Monomere **M** ist in WO 03/020790, in DE 10337346.2 und der darin zitierten Literatur niedergelegt.

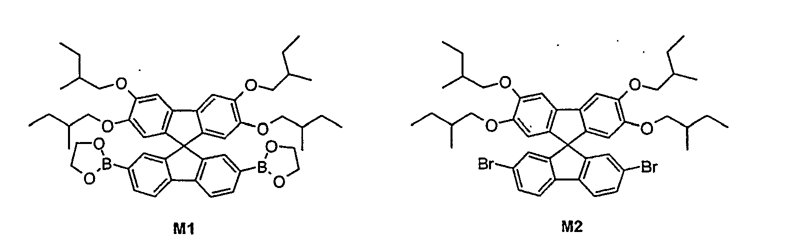

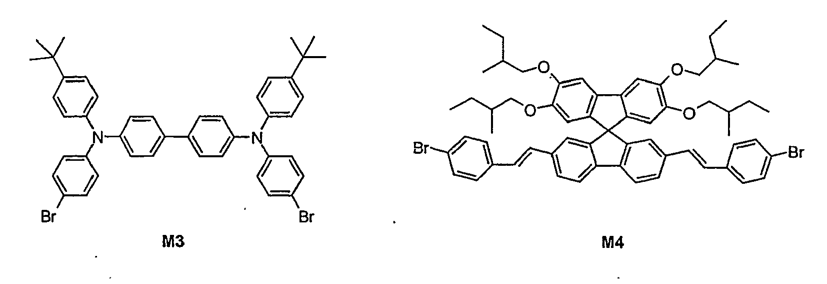

### Beispiel 3: Synthese der Polymere

Die Polymere wurden durch SUZUKI-Kupplung gemäß WO 03/048225 bzw. durch YAMAMOTO-Kupplung gemäß WO 04/022626 synthetisiert. Die Zusammensetzung der synthetisierten Polymere **P1** und **P2** ist in den Beispielen 4 und 5 zusammengefasst.

### Beispiel 4: Polymer P1 und Vergleichspolymer V1

Das Polymer **P1** wurde gemäß Beispiel 3 synthetisiert und enthält 50 mol% Monomer **M1,** 30 mol% Monomer **M2,** 10 mol% Monomer **M3** und 10 mol% Monomer **CUM1.** Ebenso wurde ein Vergleichspolymer **V1** synthetisiert (in Beispiel 7 als Standard bezeichnet), das statt Monomer **CUM1** 10 mol% Monomer **M4** enthält.

### Beispiel 5: Polymer P2

Das Polymer **P2** wurde gemäß Beispiel 3 synthetisiert und enthält 50 mol% Monomer **M1**, 40 mol% Monomer **M2** und 10 mol% Monomer **CUM1.**

### Beispiel 6: Herstellung der PLEDs

Die Polymere wurden auch für einen Einsatz in PLEDs untersucht. Die PLEDs waren jeweils Zweischichtsysteme, d. h. Substrat//ITO//PEDOTI/Polymer//Kathode. PEDOT ist ein Polythiophen-Derivat (Baytron P, von H. C. Stark, Goslar). Als Kathode wurde in allen Fällen Ba/Ag (beide von Aldrich) verwendet. Wie PLEDs dargestellt werden können, ist bereits in WO 04/037887 und der darin zitierten Literatur ausführlich beschrieben.

### Beispiel 7: Vergleich der Photostabilität

Die Photostabiliät der Polymere **P1** und **P2** wurde in einem Fluoreszenzspektrometer zusammen mit dem Vergleichspolymer **V1** ("Standard") als nächstliegenden Stand der Technik untersucht. Die Proben wurden in einer an das tatsächliche Device angelehnten Konfiguration präpariert, nämlich auf ITO, dem typischen transparenten Anodenmaterial (Schichtdicke 150 nm), und 80 nm PEDOT. Die Dicke des aufgebrachten Polymerfilms betrug 80 nm. Zunächst wurde von jedem Film ein Absorptionsspektrum und ein Photolumineszenzspektrum gemessen, dann wurde der Film im Fluoreszenzspektrometer 30 min. bei konstanter Spaltbreite (5 nm) im Absorptionsmaximum belichtet, während die Photolumineszenz im Maximum über die Zeit detektiert wurde. Der Probenraum wurde dabei mit Stickstoff gespült, um etwaige von Luftsauerstoff verursachte Effekte auszuschließen. Um die Polymere miteinander vergleichen zu können, wurde die detektierte Photolumineszenz auf 1 normiert. Nach diesem so genannten TimeScan wurde nochmals ein Photolumineszenzspektrum gemessen, um auszuschließen, daß sich während der Messung die Spektren verschoben haben könnten. In allen 3 untersuchten Fällen wurde keine relevante Verschiebung des Emissionsmaximums beobachtet.

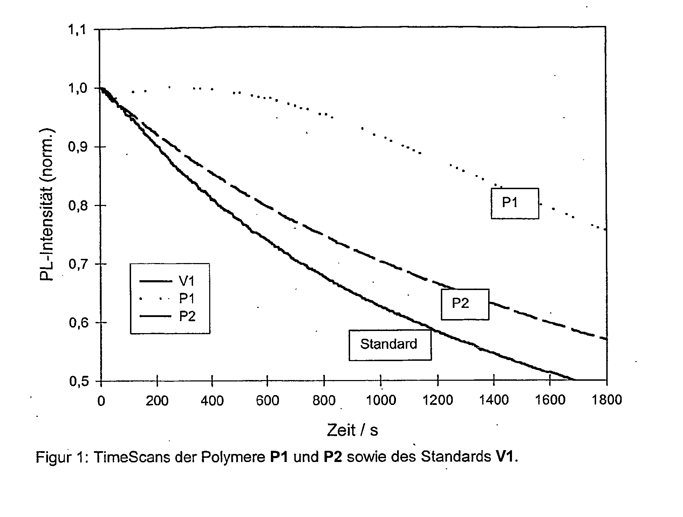

Figur 1 zeigt die Ergebnisse des TimeScans für die Polymere **P1**, **P2** und **V1** (Standard gemäß dem Stand der Technik). Während der Vergleichsstandard schon nach weniger als 30 min. nur noch die Hälfte der ursprünglichen Photolumineszenz abstrahlt, sind die Polymere **P1** und **P2** deutlich stabiler. Vor allem Polymer **P1** zeigt trotz intensiver Bestrahlung nach einer halben Stunde noch 75 % der ursprünglichen Lumineszenz. Aber auch **P2** ist im Vergleich zum Stand der Technik deutlich stabiler. Monomereinheiten gemäß Beispiel 1 sind daher geeignet, die Photostabilität und damit die Lebensdauer blauer konjugierter Polymere deutlich zu erhöhen.

## Patentansprüche

1. Konjugierte Polymere und Dendrimere, enthaltend mindestens 1 mol% Einheiten gemäß Formel (1), 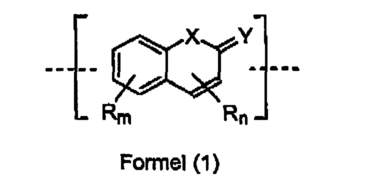 wobei die verwendeten Symbole und Indizes folgende Bedeutung besitzen:
X ist bei jedem Auftreten gleich oder verschieden Sauerstoff, Schwefel, Selen oder eine Gruppe N(R1);
Y ist bei jedem Auftreten gleich oder verschieden Sauerstoff, Schwefel oder Selen;
R ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch -C(R1)=C(R1)-, -C≡C-, -N(R1)-, -O-, -S-, -CO-O- oder -O-CO-O- ersetzt sein können, wobei auch ein oder mehrere H-Atome durch Fluor ersetzt sein können, eine Aryl-, Heteroaryl- oder Aryloxygruppe mit 5 bis 40 C-Atomen, bei der auch ein oder mehrere C-Atome durch O, S oder N ersetzt sein können und welche auch durch einen oder mehrere nicht-aromatische Reste R substituiert sein kann, wobei auch zwei oder mehrere der Reste R miteinander ein aliphatisches oder aromatisches, mono- oder polycyclisches Ringsystem bilden können, oder Fluor, Chlor, Hydroxy, CN, N(R1)₂, Si(R1)₃ oder B(R1)₂;
R1 ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O- oder -O-CO-O- ersetzt sein können, wobei auch ein oder mehrere H-Atome durch Fluor ersetzt sein können, eine Aryl- oder Heteroarylgruppe mit 5 bis 40 C-Atomen, bei der auch ein oder mehrere C-Atome durch O, S oder N ersetzt sein können und welche auch durch ein oder mehrere nicht-aromatische Reste R1 substituiert sein kann; dabei können auch mehrere Reste R1 bzw. R1 mit weiteren Resten R ein aromatisches oder aliphatisches, mono- oder polycyclisches Ringsystem bilden;
m ist bei jedem Auftreten gleich oder verschieden 0, 1, 2, 3 oder 4, mit der Maßgabe, dass m nicht 4 sein darf, wenn eine Verknüpfung zum Polymer direkt über den Carbocyclus verläuft, und mit der weiteren Maßgabe, dass m nicht 3 oder 4 sein darf, wenn beide Verknüpfungen zum Polymer direkt über den Carbocyclus verlaufen;
n ist bei jedem Auftreten gleich oder verschieden 0, 1 oder 2, mit der Maßgabe, dass n nicht 2 sein darf, wenn eine Verknüpfung zum Polymer direkt über den Heterocyclus verläuft, und mit der weiteren Maßgabe, dass n = 0 ist, wenn beide Verknüpfungen zum Polymer direkt über den Heterocyclus verlaufen;
ausgenommen konjugierte Poly(phenylenethinylene).

2. Polymere gemäß Anspruch 1, **dadurch gekennzeichnet, dass** die Einheiten gemäß Formel (1) in Konjugation zur Polymerhauptkette stehen.

3. Polymere gemäß Anspruch 1 und/oder 2, **dadurch gekennzeichnet, dass** die Einheiten gemäß Formel (1) in die Hauptkette des Polymers eingebaut sind.

4. Polymere gemäß Anspruch 3, **dadurch gekennzeichnet, dass** die Verknüpfung so erfolgt, dass eine gerade Anzahl C-Atome zwischen den Verknüpfungspunkten liegt.

5. Polymere gemäß Anspruch 1 und/oder 2, **dadurch gekennzeichnet, dass** die Einheiten gemäß Formel (1) in die Seitenkette des Polymers eingebaut werden.

6. Polymere gemäß Anspruch 5, **dadurch gekennzeichnet, dass** die Verknüpfung über die Position 5, 6, 7 oder 8 erfolgt.

7. Polymere gemäß Anspruch 5 und/oder 6, **dadurch gekennzeichnet, dass** die Verknüpfung mit der Hauptkette über aromatische Einheiten, Diarylaminoeinheiten, Triarylaminoeinheiten, Arylenvinylen- oder Arylenethinyleneinheiten erfolgt.

8. Polymere gemäß einem oder mehreren der Ansprüche 1 bis 7, **dadurch gekennzeichnet, dass** sie weitere Strukturelemente enthalten.

9. Polymere gemäß Anspruch 8, **dadurch gekennzeichnet, dass** die weiteren Strukturelemente ausgewählt sind aus den Gruppen der Fluorenylene, Spirobifluorenylene, Dihydrophenanthrenylene, indenofluorenylene, Tetrahydropyrenylene, Stilbenylene, Bisstyrylarylene, 1,4-Phenylene, 1,4-Naphthylene, 1.4- oder 9,10-Anthrylene, 1,6- oder 2,7- oder 4,9-Pyrenylene, 3,9- oder 3,10-Perylenylene, 2,7- oder 3,6-Phenanthrenylene, 4,4'-Biphenylylene, 4,4"-Terphenylylene oder 4,4'-Bi-1,1'-naphthylylene.

10. Polymere gemäß Anspruch 8, **dadurch gekennzeichnet, dass** weitere Strukturelemente ausgewählt sind aus den Gruppen der Triarylamine, Triarylphosphine, Benzidine, Tetraarylen-para-phenylendiamine, Phenothiazine, Phenoxazine, Dihydrophenazine, Thianthrene, Dibenzo-*p*-dioxine, Phenoxathiine, Carbazole, Azulene, Thiophene, Pyrrole oder Furane.

11. Polymere gemäß Anspruch 8, **dadurch gekennzeichnet, dass** weitere Strukturelemente ausgewählt sind aus den Gruppen der Pyridine, Pyrimidine, Pyridazine, Pyrazine, Triarylborane, Oxadiazole, Chinoline, Chinoxaline oder Phenazine.

12. Polymere gemäß einem oder mehreren der Ansprüche 8 bis 11, **dadurch gekennzeichnet, dass** sie mindestens 50 mol% Einheiten gemäß Anspruch 9 und 2 - 30 mol% Einheiten gemäß Anspruch 10 und/oder 11 enthalten.

13. Polymere gemäß einem oder mehreren der Ansprüche 1 bis 12, **dadurch gekennzeichnet, dass** der Anteil Struktureinheiten gemäß Formel (1) 10 bis 30 mol% beträgt.

14. Polymere gemäß einem oder mehreren der Ansprüche 1 bis 13, **dadurch gekennzeichnet, dass f**ür Einheiten gemäß Formel (1) gilt
X ist bei jedem Auftreten gleich oder verschieden Sauerstoff, Schwefel oder eine Gruppe N(R1);
Y ist bei jedem Auftreten gleich oder verschieden Sauerstoff oder Schwefel;
m ist bei jedem Auftreten gleich oder verschieden 0, 1, 2 oder 3, mit der Maßgabe, dass m nicht 3 sein darf, wenn beide Verknüpfungen zum Polymer direkt über den Carbocyclus verlaufen;
die weiteren Symbole und Indizes sind wie unter Anspruch 1 definiert.

15. Polymere gemäß Anspruch 14, **dadurch gekennzeichnet, dass** für Einheiten gemäß Formel (1) gilt:
X ist bei jedem Auftreten gleich oder verschieden Sauerstoff oder eine Gruppe N(R1);
Y ist bei jedem Auftreten Sauerstoff;
m ist bei jedem Auftreten gleich oder verschieden 0, 1 oder 2;
n ist bei jedem Auftreten gleich oder verschieden 0 oder 1;
die weiteren Symbole sind wie unter Anspruch 1 definiert.

16. Polymere gemäß einem oder mehreren der Ansprüche 1 bis 15, **dadurch gekennzeichnet, dass** die Strukturen gemäß Formel (1) aus den Strukturen gemäß Formel (2) bis (28) ausgewählt sind, 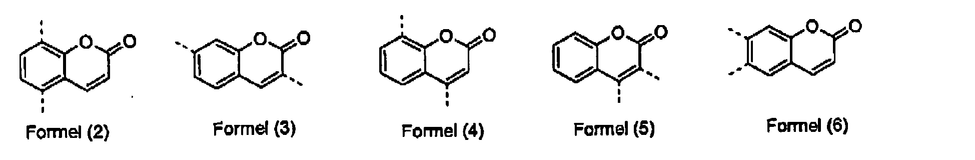 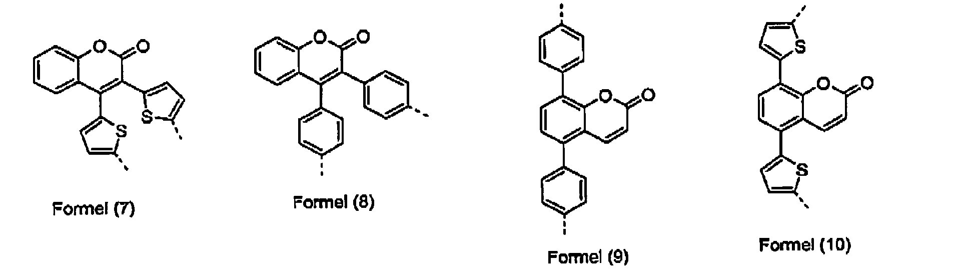 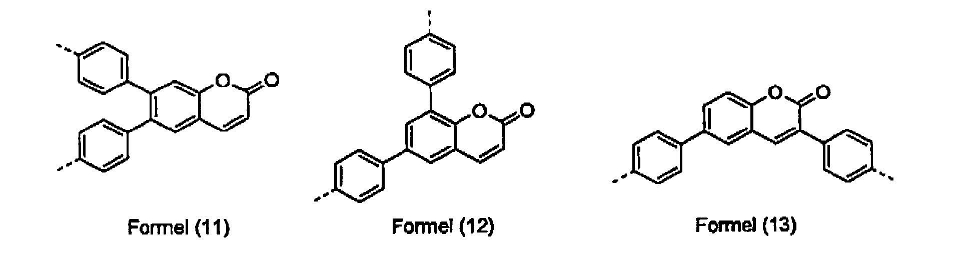 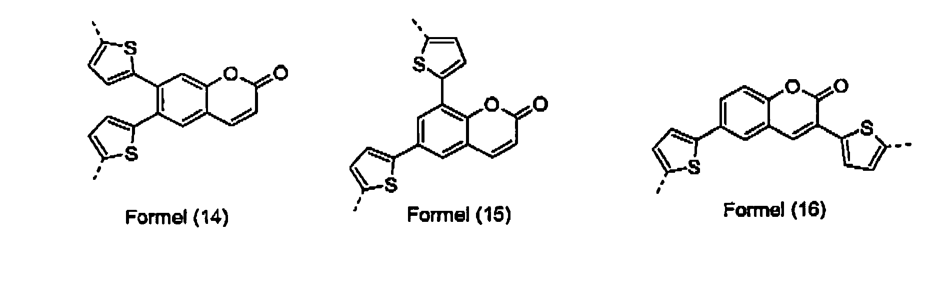 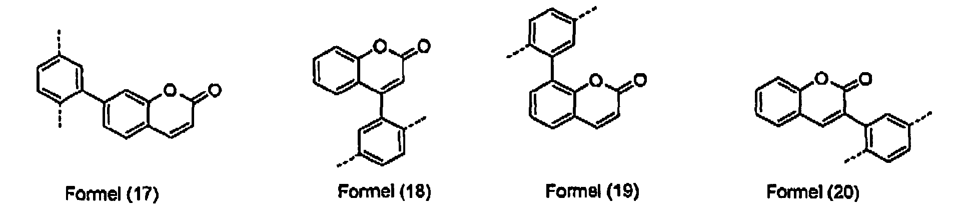 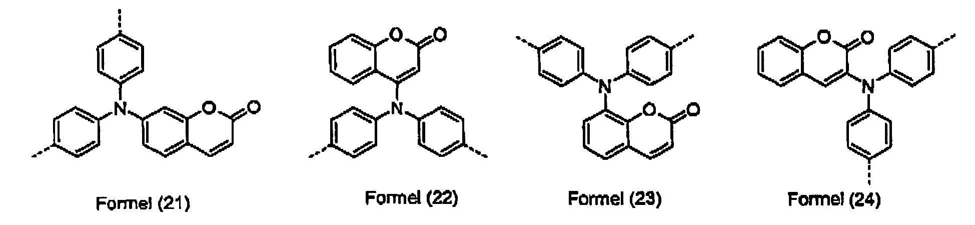 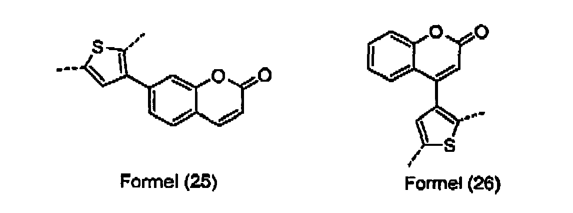 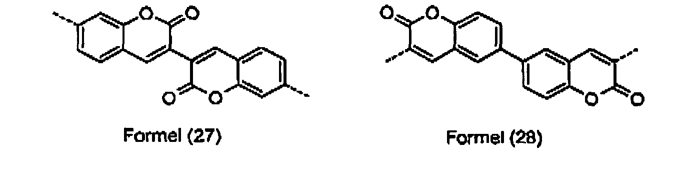 welche jeweils mit R substituiert oder unsubstituiert sind.

17. Weiß emittierende konjugierte Polymere, **dadurch gekennzeichnet, dass** sie einen Anteil von 0.01 bis 1 mol% Struktureinheiten der Formel (1) gemäß Anspruch 1 enthalten.

18. Rot emittierende konjugierte Polymere, **dadurch gekennzeichnet, dass** sie mindestens 1 mol% Struktureinheiten der Formel (1) gemäß Anspruch 1 enthalten.

19. Blend eines oder mehrerer Polymere gemäß einem oder mehreren der Ansprüche 1 bis 18 mit beliebigen polymeren, oligomeren, dendritischen oder niedermolekularen Substanzen.

20. Lösungen und Formulierungen aus einem oder mehreren erfindungsgemäßen Polymeren oder Blends gemäß einem oder mehreren der Ansprüche 1 bis 19 in einem oder mehreren Lösungsmitteln.

21. Verwendung eines Polymers gemäß einem oder mehreren der Ansprüche 1 bis 19 in einem elektronischen Bauteil, vorzugsweise in einer organischen Leuchtdiode (OLED).

22. Elektronisches Bauteil enthaltend ein oder mehrere Polymere gemäß einem oder mehreren der Ansprüche 1 bis 19.

23. Elektronisches Bauteil gemäß Anspruch 22, **dadurch gekennzeichnet, dass** es sich um einen Feld-Effekt-Transistor (O-FETs), einen organischen Dünnfilmtransistor (O-TFT), eine organische integrierte Schaltung (O-IC), eine organische Solarzelle (O-SC), eine organische Leuchtdiode (OLED) oder eine organische Laserdiode (O-Laser) handelt.

24. Organische Leuchtdiode gemäß Anspruch 23, **dadurch gekennzeichnet, dass** diese eine oder mehrere Schichten enthaltend ein oder mehrere Polymere gemäß einem oder mehreren der Ansprüche 1 bis 19 enthält.

## Claims

1. Conjugated polymers and dendrimers comprising at least 1 mol% of units of the formula (1) 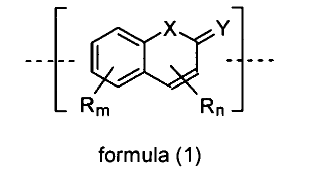 where the symbols and indices used have the following meaning:
X is on each occurrence, identically or differently, oxygen, sulfur, selenium or an N(R1) group;
Y is on each occurrence, identically or differently, oxygen, sulfur or selenium;
R is on each occurrence, identically or differently, a straight-chain, branched or cyclic alkyl or alkoxy chain having 1 to 22 C atoms, in which, in addition, one or more non-adjacent C atoms may be replaced by -C(R1)=C(R1)-, -C≡C-, -N(R1)-, -O-, -S-, -CO-O- or -O-CO-O- and in which one or more H atoms may be re- placed by fluorine, an aryl, heteroaryl or aryloxy group having 5 to 40 C atoms, in which, in addition, one or more C atoms may be replaced by O, S or N and which may also be substituted by one or more non-aromatic radicals R and in which two or more of the radicals R may form an aliphatic or aromatic, mono- or polycyclic ring system with one another, or fluorine, chlorine, hydroxyl, CN, N(R1)₂, Si(R1)₃ or B(R1)₂;
R1 is on each occurrence, identically or differently, H, a straight-chain, branched or cyclic alkyl chain having 1 to 22 C atoms, in which, in addition, one or more non- adjacent C atoms may be replaced by -O-, -S-, -CO-O- or -O-CO-O- and in which one or more H atoms may be replaced by fluorine, an aryl or heteroaryl group having 5 to 40 C atoms, in which, in addition, one or more C atoms may be re- placed by O, S or N and which may also be substituted by one or more non- aromatic radicals R1; a plurality of radicals R1 or R1 with further radicals R may also form an aromatic or aliphatic, mono- or polycyclic ring system here;
m is on each occurrence, identically or differently, 0, 1, 2, 3 or 4, with the proviso that m cannot be 4 if a link to the polymer runs directly via the carbocyclic sys- tem, and with the further proviso that m cannot be 3 or 4 if both links to the polymer run directly via the carbocyclic system;
n is on each occurrence, identically or differently, 0, 1 or 2, with the proviso that n cannot be 2 if a link to the polymer runs directly via the heterocyclic system, and with the further proviso that n = 0 if both links to the polymer run directly via the heterocyclic system;
with the exception of conjugated poly(phenyleneethynylenes).

2. Polymers according to Claim 1, **characterised in that** the units of the formula (1) are in conjugation with the polymer main chain.

3. Polymers according to Claim 1 and/or 2, **characterised in that** the units of the formula (1) are incorporated into the main chain of the polymer.

4. Polymers according to Claim 3, **characterised in that** the linking takes place in such a way that an even number of C atoms lies between the linking points.

5. Polymers according to Claim 1 and/or 2, **characterised in that** the units of the formula (1) are incorporated into the side chain of the polymer.

6. Polymers according to Claim 5, **characterised in that** the linking takes place via position 5, 6, 7 or 8.

7. Polymers according to Claim 5 and/or 6, **characterised in that** the linking to the main chain takes place via aromatic units, diarylamino units, triarylamino units, arylene-vinylene or aryleneethynylene units.

8. Polymers according to one or more of Claims 1 to 7, **characterised in that** they comprise further structural elements.

9. Polymers according to Claim 8, **characterised in that** the further structural elements are selected from the groups of the fluorenylenes, spirobifluorenylenes, dihydrophenanthrenylenes, indenofluorenylenes, tetrahydropyrenylenes, stilbenylenes, bisstyrylarylenes, 1,4-phenylenes, 1,4-naphthylenes, 1,4- or 9,10-anthrylenes, 1,6- or 2,7- or 4,9-pyrenylenes, 3,9- or 3,10-perylenylenes, 2,7- or 3,6-phenanthrenylenes, 4,4'-biphenylylenes, 4,4"-terphenylylenes or 4,4'-bi-1,1'-naphthylylenes.

10. Polymers according to Claim 8, **characterised in that** further structural elements are selected from the groups of the triarylamines, triarylphosphines, benzidines, tetraarylene-para-phenylenediamines, phenothiazines, phenoxazines, dihydrophenazines, thianthrenes, dibenzo-p-dioxins, phenoxathiynes, carbazoles, azulenes, thiophenes, pyrroles or furans.

11. Polymers according to Claim 8, **characterised in that** further structural elements are selected from the groups of the pyridines, pyrimidines, pyridazines, pyrazines, triarylboranes, oxadiazoles, quinolines, quinoxalines or phenazines.

12. Polymers according to one or more of Claims 8 to 11, **characterised in that** they comprise at least 50 mol% of units according to Claim 9 and 2 - 30 mol% of units according to Claim 10 and/or 11.

13. Polymers according to one or more of Claims 1 to 12, **characterised in that** the proportion of structural units of the formula (1) is 10 to 30 mol%.

14. Polymers according to one or more of Claims 1 to 13, **characterised in that** the following applies to units of the formula (1):
X is on each occurrence, identically or differently, oxygen, sulfur or an N(R1) group;
Y is on each occurrence, identically or differently, oxygen or sulfur;
m is on each occurrence, identically or differently, 0, 1, 2 or 3, with the proviso that m cannot be 3 if both links to the polymer run directly via the carbocyclic system;
the other symbols and indices are as defined under Claim 1.

15. Polymers according to Claim 14, **characterised in that** the following applies to units of the formula (1):
X is on each occurrence, identically or differently, oxygen or an N(R1) group;
Y is on each occurrence oxygen;
m is on each occurrence, identically or differently, 0, 1 or 2;
n is on each occurrence, identically or differently, 0 or 1;
the other symbols are as defined under Claim 1.

16. Polymers according to one or more of Claims 1 to 15, **characterised in that** the structures of the formula (1) are selected from the structures of the formulae (2) to (28): 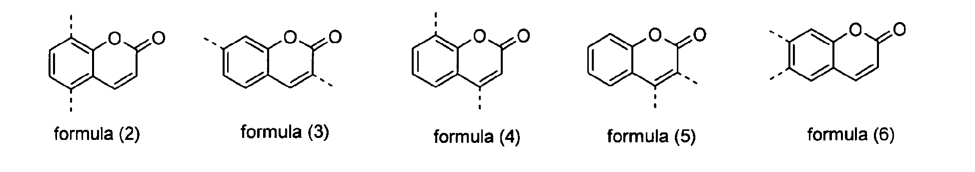 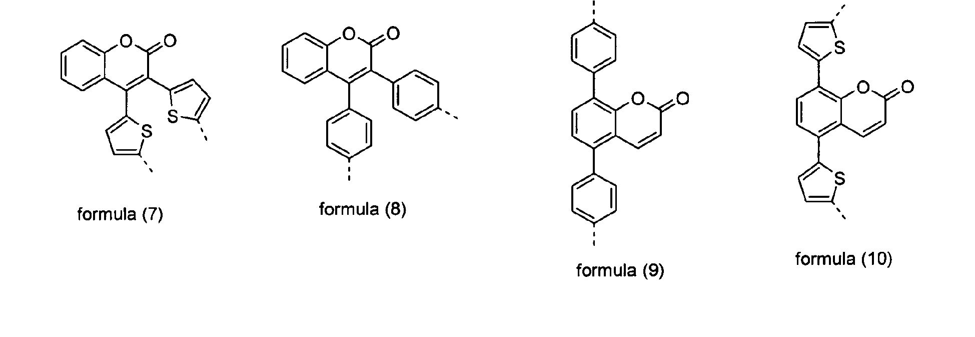 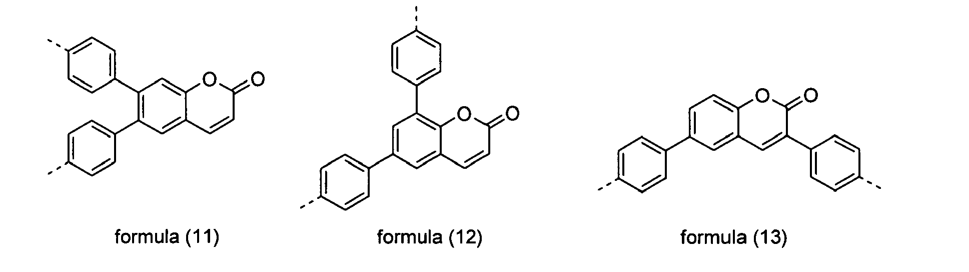 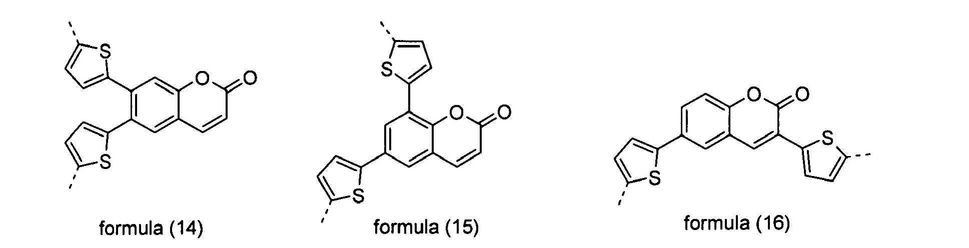 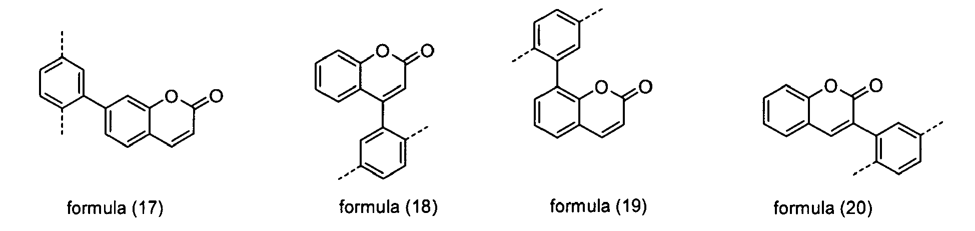 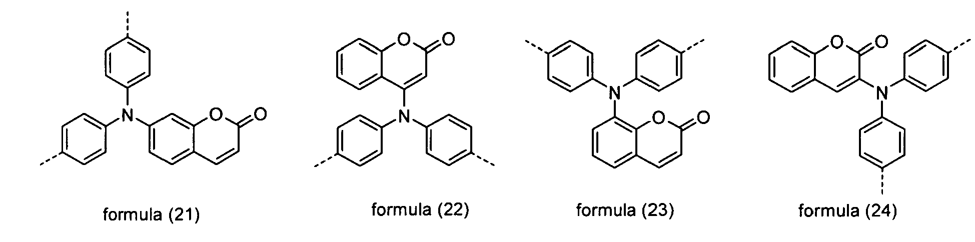 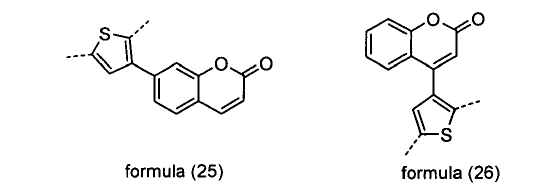 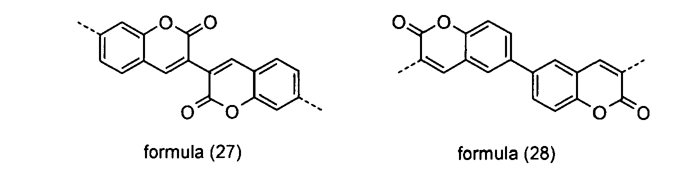 each of which is substituted by R or unsubstituted.

17. White-emitting conjugated polymers, **characterised in that** they comprise a proportion of 0.01 to 1 mol% of structural units of the formula (1) according to Claim 1.

18. Red-emitting conjugated polymers, **characterised in that** they comprise at least 1 mol% of structural units of the formula (1) according to Claim 1.

19. Blend of one or more polymers according to one or more of Claims 1 to 18 with any desired polymeric, oligomeric, dendritic or low-molecular-weight substances.

20. Solutions and formulations comprising one or more polymers or blends according to the invention according to one or more of Claims 1 to 19 in one or more solvents.

21. Use of a polymer according to one or more of Claims 1 to 19 in an electronic component, preferably in an organic light-emitting diode (OLED).

22. Electronic component comprising one or more polymers according to one or more of Claims 1 to 19.

23. Electronic component according to Claim 22, **characterised in that** it is a field-effect transistor (O-FET), an organic thin-film transistor (O-TFT), an organic integrated circuit (O-IC), an organic solar cell (O-SC), an organic light-emitting diode (OLED) or an organic laser diode (O-laser).

24. Organic light-emitting diode according to Claim 23, **characterised in that** it comprises one or more layers comprising one or more polymers according to one or more of Claims 1 to 19.

## Revendications

1. Polymères et dendrimères conjugués comprenant au moins 1 mol% d'unités de la formule (1) 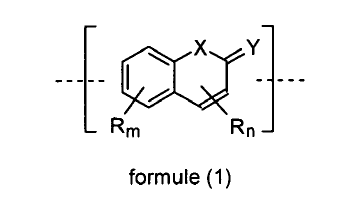 dans laquelle les symboles et indices utilisés ont la signification suivante :
X est à chaque occurrence, de façon identique ou différente, oxygène, soufre, sélé- nium ou un groupe N(R1) ;
Y est à chaque occurrence, de façon identique ou différente, oxygène, soufre ou sélénium ;
R est à chaque occurrence, de façon identique ou différente, une chaîne alkyle ou alcoxy en chaîne droite, ramifiée ou cyclique ayant 1 à 22 atomes de C, dans la- quelle, en addition, un ou plusieurs atomes de C non adjacents peuvent être remplacés par -C(R1)=C(R1)-, -C≡C-, -N(R1)-, -O-, -S-, -CO -O- ou -O-CO-O- et dans laquelle un ou plusieurs atomes de H peuvent être remplacés par fluor, un groupe aryle, hétéroaryle ou aryloxy ayant 5 à 40 atomes de C, dans lequel, en addition, un ou plusieurs atomes de C peuvent être remplacés par O, S ou N et qui peut également être substitué par un ou plusieurs radicaux non aromatiques R et dans lequel deux ou plus de deux des radicaux R peuvent former un sys- tème de cycle aliphatique ou aromatique, mono- ou polycyclique avec un autre, ou fluor, chlore, hydroxyle, CN, N(R1)₂, Si(R1)₃ ou B(R1)₂ ;
R1 est à chaque occurrence, de façon identique ou différente, H, une chaîne alkyle en chaîne droite, ramifiée ou cyclique ayant 1 à 22 atomes de C, dans laquelle, en addition, un ou plusieurs atomes de C non adjacents peuvent être remplacés par -O-, -S-, -CO-O- ou -O-CO-O- et dans laquelle un ou plusieurs atomes de H peuvent être remplacés par fluor, un groupe aryle ou hétéroaryle ayant 5 à 40 atomes de C, dans lequel, en addition, un ou plusieurs atomes de C peuvent être remplacés par O, S ou N et qui peut également être substitué par un ou plusieurs radicaux non aromatiques R1; une pluralité de radicaux R1 ou R1 avec d'autres radicaux R peuvent également former ici un système de cycle aromatique ou ali- phatique, mono- ou polycyclique;
m est à chaque occurrence, de façon identique ou différente, 0, 1, 2, 3 ou 4, avec comme condition que m ne peut pas être 4 si une liaison au polymère court directement via le système carbocyclique, et avec comme autre condition que m ne peut pas être 3 ou 4 si toutes les liaisons au polymère courent directement via le système carbocyclique ;
n est à chaque occurrence, de façon identique ou différente, 0, 1 ou 2, avec comme condition que n ne peut pas être 2 si une liaison au polymère court directement via le système hétérocyclique, et avec comme autre condition que n = 0 si toutes les liaisons au polymère courent directement via le système hétérocyclique ;
à l'exception des poly(phénylèneéthynylènes) conjugués.

2. Polymères selon la revendication 1, **caractérisés en ce que** les unités de la formule (1) sont en conjugaison avec la chaîne principale de polymère.

3. Polymères selon la revendication 1 et/ou 2, **caractérisés en ce que** les unités de la formule (1) sont incorporées dans la chaîne principale du polymère.

4. Polymères selon la revendication 3, **caractérisés en ce que** la liaison s'instaure de telle sorte qu'un nombre pair d'atomes de C s'étendent entre les points de liaison.

5. Polymères selon la revendication 1 et/ou 2, **caractérisés en ce que** les unités de la formule (1) sont incorporées dans la chaîne latérale du polymère.

6. Polymères selon la revendication 5, **caractérisés en ce que** la liaison s'instaure via la position 5, 6, 7 ou 8.

7. Polymères selon la revendication 5 et/ou 6, **caractérisés en ce que** la liaison à la chaîne principale s'instaure via des unités aromatiques, des unités diarylamino, des unités triarylamino, des unités arylènevinylène ou arylèneéthynylène.

8. Polymères selon une ou plusieurs des revendications 1 à 7, **caractérisés en ce qu'**ils comprennent des éléments structurels supplémentaires.

9. Polymères selon la revendication 8, **caractérisés en ce que** les éléments structurels supplémentaires sont choisis parmi les groupes des fluorénylènes, spirobifluorénylènes, dihydrophénanthrénylènes, indénofluorénylènes, tétrahydropyrénylènes, stilbénylènes, bisstyrylarylènes, 1,4-phénylènes, 1,4-naphtylènes, 1,4- ou 9,10-anthrylènes, 1,6- ou 2,7- ou 4,9-pyrénylènes, 3,9- ou 3,10-pérylénylènes, 2,7- ou 3,6-phénanthrénylènes, 4,4'-biphénylylènes, 4,4"-terphénylylènes ou 4,4'-bi-1,1'-naphtylylènes.

10. Polymères selon la revendication 8, **caractérisés en ce que** les éléments structurels supplémentaires sont choisis parmi les groupes des triarylamines, triarylphosphines, benzidines, tétraarylèene-para-phénylènediamines, phénothiazines, phénoxazines, dihydrophénazines, thianthrènes, dibenzo-p-dioxines, phénoxathiynes, carbazoles, azulènes, thiophènes, pyrroles ou furannes.

11. Polymères selon la revendication 8, **caractérisés en ce que** les éléments structurels supplémentaires sont choisis parmi les groupes des pyridines, pyrimidines, pyridazines, pyrazines, triarylboranes, oxadiazoles, quinolines, quinoxalines ou phénazines.

12. Polymères selon une ou plusieurs des revendications 8 à 11, **caractérisés en ce qu'**ils comprennent au moins 50 mol% d'unités selon la revendication 9 et 2 - 30 mol% d'unités selon la revendication 10 et/ou 11.

13. Polymères selon une ou plusieurs des revendications 1 à 12, **caractérisés en ce que** la proportion d'unités structurelles de la formule (1) est 10 à 30 mol%.

14. Polymères selon une ou plusieurs des revendications 1 à 13, **caractérisés en ce que** ce qui suit s'applique aux unités de la formule (1) :
X est à chaque occurrence, de façon identique ou différente, oxygène, soufre ou un groupe N(R1) ;
Y est à chaque occurrence, de façon identique ou différente, oxygène ou soufre ;
m est à chaque occurrence, de façon identique ou différente, 0, 1, 2 ou 3, avec comme condition que m ne peut pas être 3 si toutes les liaisons au polymère courent directement via le système carbocyclique ;
les autres symboles et indices sont comme défini dans la revendication 1.

15. Polymères selon la revendication 14, **caractérisés en ce que** ce qui suit s'applique aux unités de la formule (1) :
X est à chaque occurrence, de façon identique ou différente, oxygène ou un groupe N(R1);
Y est à chaque occurrence oxygène ;
m est à chaque occurrence, de façon identique ou différente, 0, 1 ou 2 ;
n est à chaque occurrence, de façon identique ou différente, 0 ou 1 ;
les autres symboles sont comme défini dans la revendication 1.

16. Polymères selon une ou plusieurs des revendications 1 à 15, **caractérisés en ce que** les structures de la formule (1) sont choisies parmi les structures des formules (2) à (28): 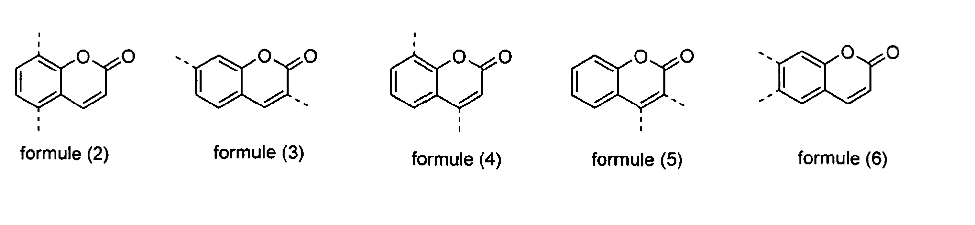 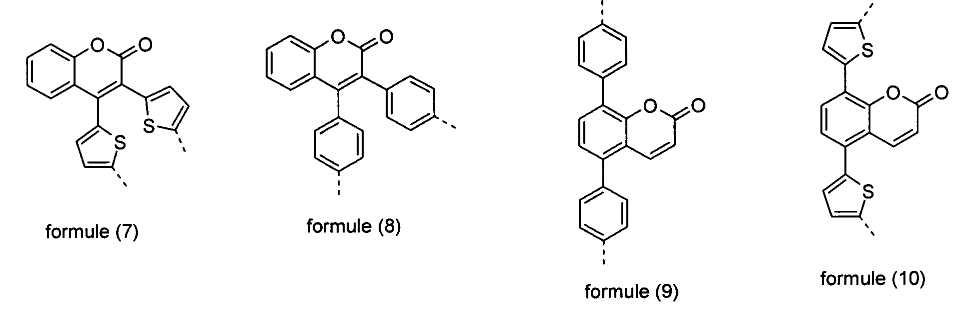 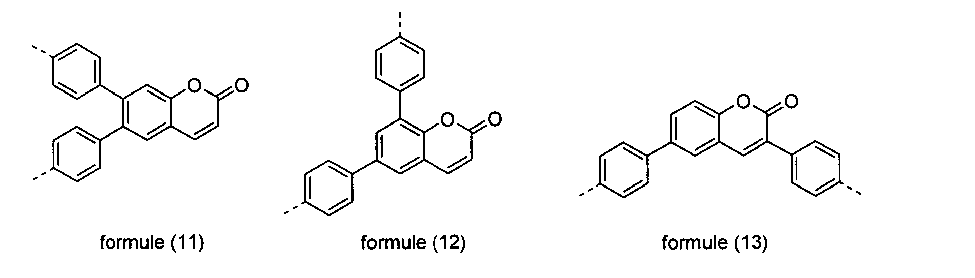 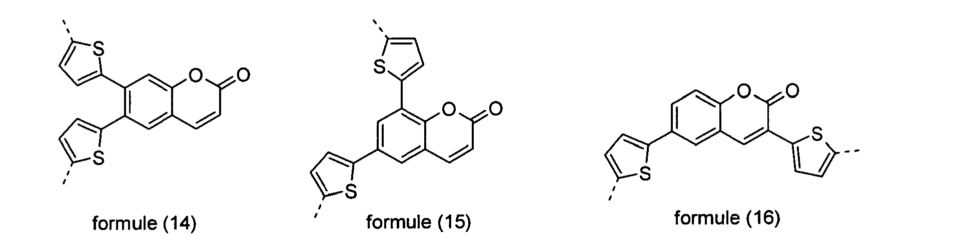 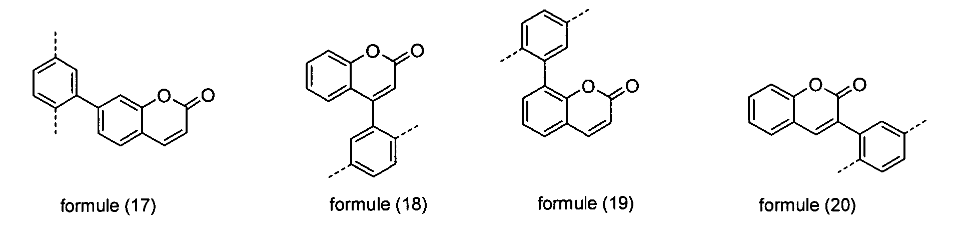 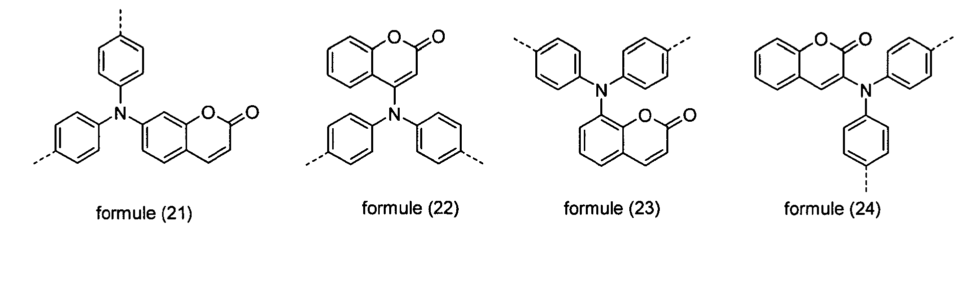 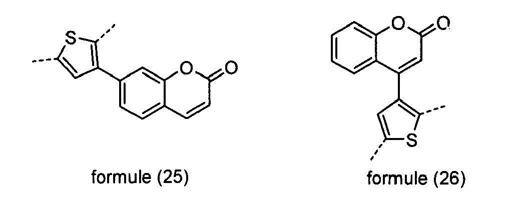 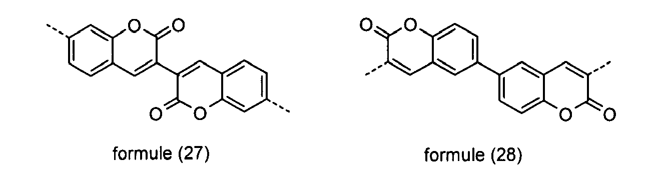 chacune d'elles est substituée par R ou non substituée.

17. Polymères conjugués d'émission blanche, **caractérisés en ce qu'**ils comprennent une proportion de 0,01 à 1 mol% d'unités structurelles de la formule (1) selon la revendication 1.

18. Polymères conjugués d'émission rouge, **caractérisés en ce que** qu'ils comprennent au moins 1 mol% d'unités structurelles de la formule (1) selon la revendication 1.

19. Mélange d'un ou plusieurs polymères selon une ou plusieurs des revendications 1 à 18 avec de quelconques substances souhaitées polymériques, oligomériques, dendritiques ou à faible poids moléculaire.

20. Solutions et formulations comprenant un ou plusieurs polymères ou mélanges selon l'invention selon une ou plusieurs des revendications 1 à 19 dans un ou plusieurs solvants.

21. Utilisation d'un polymère selon une ou plusieurs des revendications 1 à 19 dans un composant électronique, de préférence dans une diode émettrice de lumière organique (OLED).

22. Composant électronique comprenant un ou plusieurs polymères selon une ou plusieurs des revendications 1 à 19.

23. Composant électronique selon la revendication 22, **caractérisé en ce qu'**il est un transistor à effet de champ organique (O-FET), un transistor à film mince organique (O-TFT), un circuit intégré organique (O-IC), une cellule solaire organique (O-SC), une diode émettrice de lumière organique (OLED) ou une diode laser organique (O-laser).

24. Diode émettrice de lumière organique selon la revendication 23, **caractérisée en ce qu'**elle comprend une ou plusieurs couches comprenant un ou plusieurs polymères selon une ou plusieurs des revendications 1 à 19.
